# EUROPEAN PATENT APPLICATION

(11) **EP 4 697 885 A1**
(43) Date of publication of application: **18.02.2026**
(21) Application number: 24910241.9
(22) Date of filing: 25.10.2024
(51) Int. Cl.: H10B 12/00

(54) **MEMORY AND MANUFACTURING METHOD THEREFOR, AND ELECTRONIC DEVICE**

(30) Priority: 25.12.2023 CN 202311810441
(71) Applicant: CXMT Corporation, Hefei City, Anhui Province 230601 (CN)
(72) Inventor: HUANG, Meng, Hefei, Anhui 230601 (CN)
(74) Representative: Gulde & Partner
(86) International application number: PCT/CN2024/127339
(87) International publication number: WO 2025/139300

(57) **Abstract**

The present disclosure relates to a memory and a manufacturing method thereof, and an electronic device. The memory includes a common bit line, a bit line, and a cell array. The common bit line extends in a first direction parallel to a substrate. The bit line is located on a first side of the common bit line and extends in a second direction parallel to the substrate. The cell array includes a plurality of cells corresponding to the bit line, and the plurality of cells are located on a same side of the bit line and arranged in sequence in the second direction. The plurality of cells include at least one connection cell, at least one selection cell on a side of the at least one connection cell that is away from the common bit line, and a plurality of storage cells on a side of the at least one selection cell that is away from the common bit line. The storage cell and the selection cell each include a transistor coupled to the bit line. The transistor included in the selection cell is a selection transistor, and the selection transistor is coupled to the common bit line through the connection cell.

## Description

This application claims priority to Chinese Patent Application No. 202311810441.3, filed with the China National Intellectual Property Administration on December 25, 2023 and entitled "Memory and Manufacturing Method Thereof, and Electronic Device", which is incorporated herein by reference in its entirety.

### TECHNICAL FIELD

The present disclosure relates to the field of memory technologies, and in particular, to a memory and a manufacturing method thereof, and an electronic device.

### BACKGROUND

With development of semiconductor technologies, the pursuit of further miniaturization of device structures within a memory has led to a shift from planar to three-dimensional architectures, that is, three-dimensional spatial arrangement is performed on memory cells and related signal lines in the memory, which has become a primary focus in the current research on memory structures.

Currently, in a three-dimensional memory, a bit line and a common bit line may extend in different directions parallel to a substrate, and the bit line may be coupled to the common bit line through a selection transistor. However, the selection transistor is usually disposed between the bit line and the common bit line, and a production yield of the selection transistor is susceptible to an etching loading effect, which can lead to a memory failure.

### SUMMARY

Based on this, embodiments of the present disclosure provide a memory and a manufacturing method thereof, and an electronic device, so as to improve a production yield of a selection transistor, thereby improving a production yield and performance of a memory and an electronic device.

To achieve the foregoing objective, in one aspect, some embodiments of the present disclosure provide a memory, including a common bit line, a bit line, and a cell array. The common bit line extends in a first direction parallel to the substrate. The bit line is located on a first side of the common bit line and extends in a second direction parallel to the substrate. The second direction intersects the first direction. The cell array includes a plurality of cells corresponding to the bit line BL, and the plurality of cells are located on a same side of the bit line BL and arranged in sequence in the second direction. The plurality of cells include at least one connection cell, at least one selection cell on a side of the at least one connection cell that is away from the common bit line, and a plurality of storage cells on a side of the at least one selection cell that is away from the common bit line. The storage cell and the selection cell each include a transistor coupled to the bit line. The transistor included in the selection cell is a selection transistor, and the selection transistor is coupled to the common bit line through the connection cell.

In some embodiments of the present disclosure, the transistor included in the storage cell is an access transistor. The storage cell further includes a capacitor, and the capacitor includes a first electrode coupled to the access transistor, a second electrode disposed opposite to the first electrode, and a dielectric layer located between the first electrode and the second electrode. The selection cell and the connection cell each include a first electrode dummy structure. The first electrode dummy structures in the selection cell and the connection cell corresponding to a bit line are interconnected. A selection transistor in a selection cell is coupled to a first electrode dummy structure of the selection cell. The first electrode dummy structure in the connection cell close to the common bit line is coupled to the common bit line.

In some embodiments of the present disclosure, the cell includes a first hole whose axis is perpendicular to the substrate, and a first accommodation groove that extends in a direction parallel to the substrate and that is located on a sidewall of the first hole. The first electrode and the first electrode dummy structure each conformally cover an inner sidewall of a corresponding first accommodation groove. The dielectric layer conformally covers the first electrode and the sidewall of the first hole. The second electrode covers the dielectric layer and fills the first accommodation groove and the first hole. The selection cell and the connection cell each further include a support electrode covering the first electrode dummy structure and filling the first accommodation groove, and a first filling layer filling the first hole.

In some embodiments of the present disclosure, the cell further includes a second hole that is located between the bit line and the first hole and whose axis is perpendicular to the substrate. The storage cell and the selection cell each further include a second accommodation groove that extends in a direction parallel to the substrate and that is located on a sidewall of the second hole. A sidewall of the bit line and a sidewall corresponding to the first electrode or the first electrode dummy structure are respectively exposed on the two opposite sides of the second accommodation groove in the first direction. The transistor includes a semiconductor layer that conformally covers an inner sidewall of the corresponding second accommodation groove, and a gate insulating layer that conformally covers the semiconductor layer and the sidewall of the second hole. The memory further includes a word line that covers the gate insulating layer and fills the second hole in the storage cell, and a selection line that covers the gate insulating layer and fills the second hole in the selection cell. The connection cell further includes a second filling layer that fills the second hole.

In some embodiments of the present disclosure, the cell further includes a second hole that is located between the bit line and the first hole and whose axis is perpendicular to the substrate. The sidewall of the bit line and the sidewall of the corresponding first electrode or the sidewall of the corresponding first electrode dummy structure are respectively exposed on two opposite sides of the second hole in the first direction. The access transistor and the selection transistor each further include a semiconductor layer and a gate insulating layer that are formed on an inner sidewall of the second hole. Semiconductor layers of adjacent access transistors are insulated from each other in a direction perpendicular to the substrate, and semiconductor layers of adjacent selection transistors are insulated from each other in a direction perpendicular to the substrate. The memory further includes a word line that covers the gate insulating layer and fills the second hole in the storage cell, and a selection line that covers the gate insulating layer and fills the second hole in the selection cell. The connection cell further includes a second filling layer that fills the second hole.

In some embodiments of the present disclosure, the bit line includes a first part opposite to the storage cell and the selection cell, and a second part opposite to the connection cell. The second part and the common bit line are an integrated structure. The memory further includes an isolation structure located between the first part and the second part.

In some embodiments of the present disclosure, one bit line corresponds to at least two connection cells. The isolation structure includes a first isolation part located between the first part and the second part, and a second isolation part including at least a part of the second filling layer and being at least connected to the first isolation part.

In some embodiments of the present disclosure, there are a plurality of bit lines, and the plurality of bit lines are insulated and arranged in a direction parallel to the substrate and are insulated and stacked in a direction perpendicular to the substrate. Every two adjacent bit lines in the direction parallel to the substrate form a bit line group. Cells corresponding to any bit line in the bit line group are located on a same side of the bit line that is away from the other bit line.

In some embodiments of the present disclosure, there are a plurality of common bit lines, and the plurality of common bit lines are insulated and stacked in a direction perpendicular to the substrate. The memory further includes a staircase structure on a side of the common bit line that is away from the bit line. The staircase structure includes a plurality of conductive stairs that are correspondingly coupled to the common bit lines.

According to another aspect, some embodiments of the present disclosure further provide a manufacturing method of a memory, which is used to manufacture the memory in the foregoing embodiments. The manufacturing method includes the following steps.

A plurality of first dielectric layers and a plurality of second dielectric layers are alternately stacked on a substrate.

The plurality of first dielectric layers and the plurality of second dielectric layers are etched along a direction perpendicular to the substrate, to form a first etching groove that extends in a first direction parallel to the substrate, and at least one second etching groove that is located on a side of the first etching groove and that extends in a second direction parallel to the substrate. The second direction intersects the first direction.

The second dielectric layers are etched along a direction parallel to the substrate based on the first etching groove, to form a plurality of common bit line accommodation grooves. A common bit line is formed in the common bit line accommodation groove.

The second dielectric layers are etched along a direction parallel to the substrate based on the second etching groove, to form a plurality of bit line accommodation grooves. A bit line is formed in the bit line accommodation groove.

The plurality of first dielectric layers and the plurality of second dielectric layers are etched along a direction perpendicular to the substrate, to form an etching hole array. The etching hole array includes a plurality of etching hole groups that are sequentially arranged on a same side of a corresponding bit line in the second direction. The plurality of etching hole groups include a plurality of first etching hole groups that are distributed at intervals in the second direction, at least one second etching hole group that is located on a side of the plurality of first etching hole groups that is close to a common bit line, and at least one third etching hole group that is located on a side of the at least one second etching hole group that is close to the common bit line.

A storage cell is formed based on the first etching hole group, and the storage cell includes an access transistor coupled to a corresponding bit line.

A selection cell is formed based on the second etching hole group, and the selection cell includes a selection transistor coupled to a corresponding bit line.

A connection cell is formed based on the third etching hole group, and the selection transistor corresponding to the same bit line is further coupled to the common bit line through a corresponding connection cell.

In some embodiments of the present disclosure, the etching hole array is formed before the common bit line accommodation groove and the bit line accommodation groove are formed; and the first etching hole group, the second etching hole group, and the third etching hole group each include a first hole whose axis is perpendicular to the substrate.

Correspondingly, the manufacturing method of the memory further includes the following steps.

Each etching hole of the etching hole array is filled with a third dielectric layer.

The third dielectric layer is removed from each first hole after the common bit line is formed.

The second dielectric layer is etched along a direction parallel to the substrate based on the first hole, to form a first accommodation groove.

Correspondingly, that the storage cell is formed based on the first etching hole group includes the step as follows: A first electrode that conformally covers an inner sidewall of the first accommodation groove is formed, a dielectric layer that conformally covers the first electrode and the sidewall of the first hole is formed, and a second electrode that covers the dielectric layer and fills the first accommodation groove and the first hole is formed.

The forming the selection cell based on the second etching hole group and the forming the connection cell based on the third etching hole group each include the step as follows: A first electrode dummy structure conformally covering the inner sidewall of the corresponding first accommodation groove is formed.

As described above, first electrode dummy structures in the selection cell and the connection cell corresponding to a same bit line are interconnected. A selection transistor in a selection cell is coupled to a first electrode dummy structure of the same selection cell. The first electrode dummy structure in the connection cell close to the common bit line is coupled to the common bit line.

In some embodiments of the present disclosure, the forming the selection cell based on the second etching hole group and the forming the connection cell based on the third etching hole group each include the step as follows: A support electrode covering the first electrode dummy structure and filling the first accommodation groove is formed, and a first filling layer filling the first hole is formed.

In some embodiments of the present disclosure, the first etching hole group, the second etching hole group, and the third etching hole group each further include a second hole that is located between the bit line and the first hole and whose axis is perpendicular to the substrate.

Correspondingly, the forming the storage cell based on the first etching hole group and the forming the selection cell based on the second etching hole group each include the following steps.

The third dielectric layer is removed from the second hole.

The second dielectric layer is etched along a direction parallel to the substrate based on the second hole, to form a second accommodation groove. A sidewall of the bit line and a sidewall corresponding to the first electrode or the first electrode dummy structure are respectively exposed on the two opposite sides of the second accommodation groove in the first direction.

A semiconductor layer conformally covering an inner sidewall of the corresponding second accommodation groove is formed.

A gate insulating layer conformally covering the semiconductor layer and a sidewall of the second hole is formed.

Correspondingly, the manufacturing method of the memory further includes the following step: A word line that covers the gate insulating layer and fills the second hole in the storage cell is formed, and a selection line that covers the gate insulating layer and fills the second hole in the selection cell is formed.

In other embodiments of the present disclosure, the manufacturing method of the memory further includes the following step: The first etching groove and the second etching groove are filled with a first isolation layer before the memory cell, the selection cell, and the connection cell are formed.

In addition, the first etching hole group, the second etching hole group, and the third etching hole group each further include a second hole that is located between the bit line and the first hole and whose axis is perpendicular to the substrate. A sidewall of the bit line and a sidewall corresponding to the first electrode or the first electrode dummy structure are respectively exposed on the two opposite sides of the second hole in the first direction. Correspondingly, the forming the storage cell based on the first etching hole group and the forming the selection cell based on the second etching hole group each include the following steps.

The third dielectric layer is removed from the second hole.

An initial semiconductor layer and a gate insulating layer are sequentially formed on an inner sidewall of the second hole.

A word line that covers the gate insulating layer and fills the second hole in the storage cell is formed, and a selection line that covers the gate insulating layer and fills the second hole in the selection cell is formed.

The first isolation layer is removed from the second etching groove.

The first dielectric layers are etched along the first direction until a sidewall of the initial semiconductor layer that is away from the gate insulating layer is exposed.

The initial semiconductor layer between any adjacent second dielectric layers are etched and removed to form a plurality of semiconductor layers disposed at intervals in a direction perpendicular to the substrate.

A second isolation layer filling a spacing between the adjacent semiconductor layers, a region with the first dielectric layer being removed, and the second etching groove is formed.

In some embodiments of the present disclosure, one bit line corresponds to at least two connection cells. The first etching hole group, the second etching hole group, and the third etching hole group each further include a second hole that is located between the bit line and the first hole and whose axis is perpendicular to the substrate. A bit line is formed in the bit line accommodation groove, including the following steps.

An initial bit line is formed in the bit line accommodation groove.

The third dielectric layer in the second hole in any third etching hole group is removed after the storage cell, the selection cell, and the connection cell are formed, and the initial bit line is etched and cut off in a direction parallel to the substrate based on the second hole, to form the bit line. The bit line includes a first part opposite to the storage cell and the selection cell, and a second part opposite to the connection cell.

An isolation structure is formed in the cut-off region of the initial bit line and the second hole connected thereto.

In some embodiments of the present disclosure, an end of the bit line accommodation groove close to the common bit line accommodation groove is connected to the common bit line accommodation groove. The common bit line and the initial bit line are simultaneously formed. The second part of the bit line and the common bit line are an integrated structure.

In some embodiments of the present disclosure, after the common bit line and the initial bit line are formed, and before the storage cell, the selection cell, and the connection cell are formed, the manufacturing method of the memory further includes the following steps.

The plurality of first dielectric layers and the plurality of second dielectric layers are etched along a direction perpendicular to the substrate, and a third etching groove is formed on a side of the common bit line that is away from the initial bit line.

The first dielectric layers are etched based on the third etching groove, to form a plurality of insulating stairs.

The second dielectric layers are etched based on the third etching groove, to form a plurality of conductive stair accommodation grooves. A sidewall corresponding to the common bit line is exposed by the conductive stair accommodation groove.

A conductive stair coupled to the common bit line is formed in the conductive stair accommodation groove. The conductive stairs and the insulating stairs jointly form a staircase structure.

A cover layer covering the staircase structure is formed.

According to still another aspect, some embodiments of the present disclosure further provide a memory, including a common bit line, a bit line, a dummy line, a selection line, a word line, an access transistor, a capacitor, and a selection transistor. The common bit line extends in a first direction parallel to the substrate. The bit line is located on a first side of the common bit line and extends in a second direction parallel to the substrate. The second direction intersects the first direction. The dummy line, the selection line, and the word line are all located on a first side of the common bit line and all located on a same side of the bit line, and all extend in a third direction perpendicular to the substrate. The dummy line, the selection line, and the word line are arranged in sequence in the second direction and are sequentially away from the common bit line. The access transistor is coupled to the word line and the bit line. The capacitor is located on a side of the access transistor away from the bit line and coupled to the access transistor. The selection transistor is coupled to the selection line, the bit line, and the common bit line.

In some embodiments of the present disclosure, the memory further includes a connection electrode. The connection electrode is located between the capacitor and the common bit line. The selection transistor is coupled to the common bit line through the connection electrode.

According to still another aspect, some embodiments of the present disclosure further provide an electronic device, including the memory described in the foregoing embodiments and a processor coupled to the memory.

The embodiments of the present disclosure may/at least have the following advantages:

In embodiments of the present disclosure, the plurality of cells (that is, the cell array) arranged in sequence in the second direction are disposed on the same side of the bit line extending in the second direction, the plurality of cells may be used as a plurality of storage cells, at least one selection cell, and at least one connection cell that are arranged in sequence in a direction closer to the common bit line, and the selection transistor of the selection cell is coupled to the common bit line through the connection cell. In this way, in embodiments of the present disclosure, an etching loading effect in a manufacturing process of the cell array can be effectively reduced or eliminated based on distribution of cells in the cell array, so as to effectively improve a production yield of the selection transistor, thereby improving a production yield and performance of the memory and an electronic device.

The details of one or more embodiments of the present disclosure are set forth in the following accompanying drawings and description. Other features, objectives, and advantages of the present disclosure will become apparent from the specification, drawings, and claims.

### BRIEF DESCRIPTION OF DRAWINGS

To describe the technical solutions in the embodiments of the present disclosure or the conventional technologies more clearly, the following briefly describes the accompanying drawings required for describing the embodiments or the conventional technologies. Clearly, the accompanying drawings in the following description show merely some embodiments of the present disclosure, and a person of ordinary skill in the art may still derive other drawings from these accompanying drawings without creative efforts.
FIG. 1 is a schematic diagram of a partial structure of a memory according to some embodiments;
FIG. 2 is a schematic diagram of location distribution of bit lines, a common bit line, and a cell array on a substrate according to some embodiments;
FIG. 3 is a schematic diagram of a cross section, which is perpendicular to a substrate, of the memory taken along line B-B as shown in FIG. 1;
FIG. 4 is another schematic diagram of a cross section, which is perpendicular to a substrate, of the memory taken along line B-B as shown in FIG. 1;
FIG. 5 is a schematic flowchart of a manufacturing method of a memory according to some embodiments;
FIG. 6 is a schematic diagram of a structure obtained after a plurality of first dielectric layers and a plurality of second dielectric layers are formed according to some embodiments;
FIG. 7 is a schematic diagram of a structure obtained after a plurality of etching hole groups are formed according to some embodiments;
FIG. 8 is a schematic diagram of a structure obtained after filling with a third dielectric layer according to some embodiments;
FIG. 9 is a schematic diagram of a structure obtained after a common bit line and an initial bit line are formed according to some embodiments;
FIG. 10 is a schematic diagram of a structure obtained after a staircase structure is formed according to some embodiments;
FIG. 11 is a schematic diagram of a structure obtained after a connection cell is formed according to some embodiments;
FIG. 12 is a schematic diagram of a structure obtained after a semiconductor layer, a gate insulating layer, a word line, and a selection line are formed according to some embodiments;
FIG. 13 is a schematic diagram of a structure obtained after a capacitor is formed according to some embodiments;
FIG. 14 is a schematic diagram of a structure obtained after a bit line and an isolation structure are formed according to some embodiments;
FIG. 15 is a schematic diagram of another structure obtained after an initial semiconductor layer, a gate insulating layer, a word line, and a selection line are formed according to some embodiments;
FIG. 16 is a schematic diagram of another structure obtained after a semiconductor layer and a capacitor are formed according to some embodiments; and
FIG. 17 is a schematic diagram of another structure obtained after a bit line and an isolation structure are formed according to some embodiments.

### Descriptions of reference numerals:

CBL-Common bit line, BL-Bit line, BLA-Initial bit line, BLa-First part, BLb-Second part, N-Cell array, U1-Storage cell, U2-Selection cell, U3-Connection cell, T1-Access transistor, T2-Selection transistor, M1-First etching hole group, M2-Second etching hole group, M3-Third etching hole group, C-Capacitor, H1-First hole, H2-Second hole, WL-Word line, SL-Selection line, DL-Dummy line, S-Staircase structure, S1-Insulating stair, S2-Conductive stair, L1-First dielectric layer, L2-Second dielectric layer, L3-Third dielectric layer;
1-Substrate, 21-First electrode, 22-Dielectric layer, 23-Second electrode, 31-First electrode dummy structure, 32-Support electrode, 33-First filling layer, 34-Second filling layer, 41-Semiconductor layer, 41A-Initial semiconductor layer, 42-Gate insulating layer, 5-Isolation structure, 61-First isolation layer, 611-Silicon nitride layer, 612-Aluminium oxide layer, 62-Second isolation layer, 71-Titanium nitride layer, 72-Tungsten metal layer, 81-Barrier wall, 82-Cover layer, 821-First sub-layer, 822-Second sub-layer, 9-Connection electrode.

### DESCRIPTION OF EMBODIMENTS

For ease of understanding of the present disclosure, a more comprehensive description of the present disclosure is provided below with reference to related accompanying drawings. A preferred embodiment of the present disclosure is provided in the accompanying drawings. However, the present disclosure may be implemented in many different forms, and is not limited to the embodiments described in this specification. On the contrary, the purpose of providing these embodiments is to make the content of the present disclosure more thorough and comprehensive.

Unless otherwise defined, all technical and scientific terms employed in this specification have meanings the same as those commonly understood by a person skilled in the technical field of the present disclosure. The terms employed in the specification of the present disclosure are merely intended to describe specific embodiments, and are not intended to limit the present disclosure.

It should be understood that, although the terms "first", "second", "third", and the like may be utilized to describe various elements, components, regions, layers, and/or portions, these elements, components, regions, layers, and/or portions shall not be limited by these terms. These terms are merely utilized to distinguish one element, component, region, layer, or portion from another element, component, region, layer, or portion. Therefore, a first element, component, region, layer, or portion discussed below may be represented as a second element, component, region, layer, or portion without departing from the teachings of the present invention.

It should be understood that when one element is considered to be "coupled" to another element, it may be connected directly to the another element, or may be connected to the another element via an intermediate element. In addition, the "coupling" in the following embodiments is understood as "electrical connection", "communication connection", and the like if there is transfer of electrical signals or data between connected objects.

It should be understood that, the singular forms of "a", "an", and "the" may also be intended to include plural forms unless otherwise clearly specified in the context. It should also be understood that the term "comprise/include" or "have" specifies the presence of the stated features, entireties, steps, operations, components, portions or combinations thereof, but does not rule out the possibility of the presence or addition of one or more other features, entireties, steps, operations, components, portions or combinations thereof.

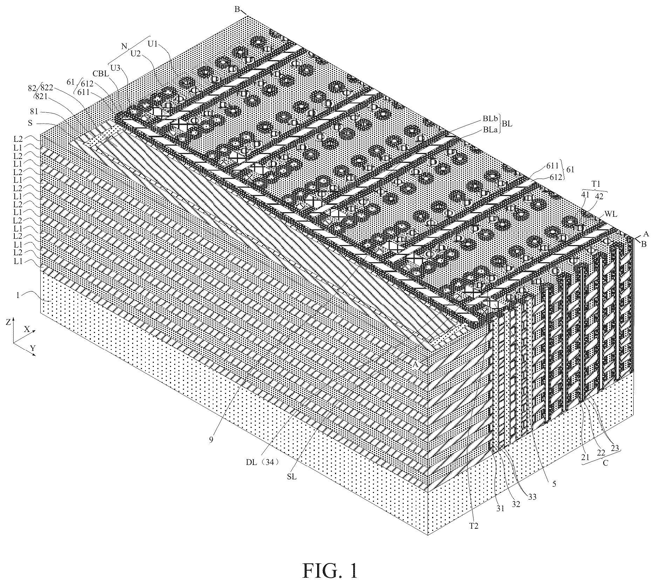

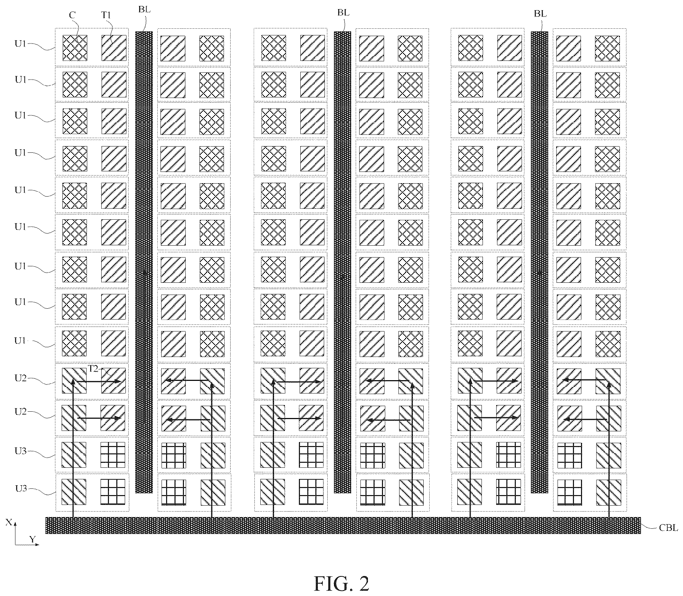

Refer to FIG. 1 and FIG. 2. Some embodiments of the present disclosure provide a memory, including a common bit line CBL, a bit line BL, and a cell array N. The common bit line CBL extends in a first direction (e.g., the Y direction) parallel to a substrate 1. The bit line BL is located on a first side of the common bit line CBL and extends in a second direction (e.g., the X direction) parallel to the substrate 1. The second direction (e.g., the X direction) intersects the first direction (e.g., the Y direction). The cell array N includes a plurality of cells corresponding to the bit line BL, and the plurality of cells are located on a same side of the bit line BL and arranged in sequence in the second direction (e.g., the X direction). The plurality of cells include at least one connection cell U3, at least one selection cell U2 on a side of the at least one connection cell U3 that is away from the common bit line CBL, and a plurality of storage cells U1 on a side of the at least one selection cell U2 that is away from the common bit line CBL. The storage cell U1 and the selection cell U2 each include a transistor coupled to the bit line BL. The transistor included in the storage cell U1 is an access transistor T1. The transistor included in the selection cell U2 is a selection transistor T2, and the selection transistor T2 is coupled to the common bit line CBL through the connection cell U3.

For example, the common bit line CBL and the bit line BL are composed of substantially the same materials. In embodiments of the present disclosure, "substantially the same" means a similarity of at least 85% or more.

For example, the cell array N may be arranged into one layer. Alternatively, the cell array N may be a plurality of layers stacked in a third direction (e.g., the Z direction) perpendicular to the substrate 1, so as to form a three-dimensional memory.

In embodiments of the present disclosure, the plurality of cells (that is, the cell array N) arranged in sequence in the second direction (e.g., the X direction) are disposed on the same side of the bit line BL extending in the second direction (e.g., the X direction), the plurality of cells may be used as a plurality of storage cells U1, at least one selection cell U2, and at least one connection cell U3 that are arranged in sequence in a direction closer to the common bit line CBL, and the selection transistor T2 of the selection cell U2 is coupled to the common bit line CBL through the connection cell U3. In this way, in embodiments of the present disclosure, an etching loading effect in a manufacturing process of the cell array N can be effectively reduced or eliminated based on distribution of cells in the cell array N, so as to effectively improve a production yield of the selection transistor T2, thereby improving a production yield and performance of the memory and an electronic device.

In some embodiments of the present disclosure, continue to refer to FIG. 1 and FIG. 2. The storage cell U1 further includes a capacitor C. The capacitor C includes a first electrode 21 coupled to the access transistor T1, a second electrode 23 disposed opposite to the first electrode 21, and a dielectric layer 22 located between the first electrode 21 and the second electrode 23. The selection cell U2 and the connection cell U3 each include a first electrode dummy structure 31. The first electrode dummy structures 31 in the selection cell U2 and the connection cell U3 corresponding to the bit line BL are interconnected, so as to form a connection electrode 9. The selection transistor T2 in the selection cell U2 is coupled to the first electrode dummy structure 31 of the selection cell. The first electrode dummy structure 31 in the connection cell U3 close to the common bit line CBL is coupled to the common bit line CBL.

In FIG. 1 and FIG. 2, two selection cells U2 and two connection cells U3 are used as examples, but quantities of selection cells U2 and connection cells U3 are not limited thereto. For example, one bit line BL may correspond to one, three, or more selection cells U2. Selection transistors T2 of the plurality of selection cells U2 may operate as parallel transistors, to improve performance of the selection transistor T2 corresponding to any bit line BL. In addition, FIG. 2 is merely a schematic diagram of a relative location relationship between the bit lines BL, the common bit line CBL, the storage cells U1, the selection cells U2, and the connection cells U3, but not a limitation on specific positions, contour shapes, connection relationships, and the like of the bit lines BL, the common bit line CBL, the storage cells U1, the selection cells U2, and the connection cells U3. In addition, in FIG. 2, a current direction between the common bit line CBL and the bit line BL is identified by black arrows. That is, the current may start from the common bit line CBL, be transmitted to the bit line BL through the connection cells U3 and the selection cells U2 in sequence, and then be transmitted to each storage cell U1 through the bit line BL.

In some embodiments of the present disclosure, with reference to FIG. 1, each cell in the cell array N includes a first hole whose axis is perpendicular to the substrate 1, and a first accommodation groove that extends in a direction parallel to the substrate 1 and that is located on a sidewall of the first hole. The first electrode 21 and the first electrode dummy structure 31 each conformally cover an inner sidewall of a corresponding first accommodation groove. The dielectric layer 22 conformally covers the first electrode 21 and the sidewall of the first hole. The second electrode 23 covers the dielectric layer 22 and fills the first accommodation groove and the first hole.

In some examples, as shown in FIG. 1, the selection cell U2 and the connection cell U3 each further include a support electrode 32 that covers the first electrode dummy structure 31 and fills the first accommodation groove, and a first filling layer 33 that fills the first hole.

For example, the connection electrode 9 may further include support electrodes 32 that are in contact with and connected to the first electrode dummy structures 31 in the selection cell U2 and the connection cell U3.

In other examples, optionally, the first electrode dummy structures 31 in the selection cell U2 and the connection cell U3 may fill the first accommodation groove, and the selection cell U2 and the connection cell U3 each further include a first filling layer 33 that fills the first hole. Correspondingly, the connection electrode 9 may be formed only by connecting the first electrode dummy structures 31 in the selection cell U2 and the connection cell U3.

For example, the first hole includes but is not limited to a circular hole, an elliptical hole, or a rectangular hole. The first accommodation groove surrounds a peripheral side of the first hole, and is a ring groove.

For example, the first electrode 21 and the first electrode dummy structure 31 include but are not limited to a titanium nitride layer or a stacked structure with a titanium nitride layer and a tungsten layer.

For example, the first electrode 21 and the first electrode dummy structure 31 are composed of substantially the same materials.

For example, the first electrode 21 and the first electrode dummy structure 31 are simultaneously formed.

For example, the support electrode 32 includes but is not limited to a polysilicon layer.

For example, the first filling layer 33 may be a single-layer structure, or may be a stacked structure. The first filling layer 33 is, for example, a stacked structure with a silicon nitride layer and a silicon oxide layer.

For example, the dielectric layer 22 is a high K dielectric layer, including but not limited to a hafnium oxide layer. K is a dielectric constant, and high K refers to a K value greater than 3.9.

For example, the second electrode 23 includes but is not limited to a polysilicon layer or a stacked structure with a titanium nitride layer and a polysilicon layer.

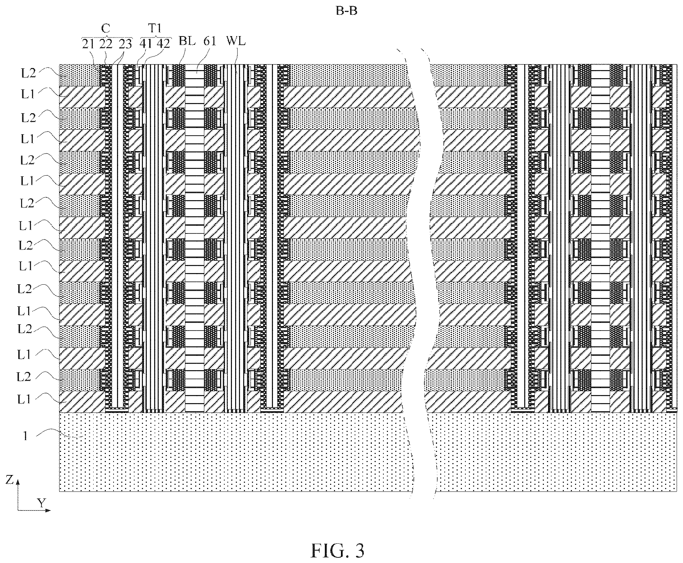

In some embodiments of the present disclosure, with reference to FIG. 1 and FIG. 3, each cell in the cell array N further includes a second hole that is located between the bit line BL and the first hole and whose axis is perpendicular to the substrate 1. The storage cell U1 and the selection cell U2 each further include a second accommodation groove that extends in a direction parallel to the substrate 1 and that is located on a sidewall of the second hole. A sidewall of the bit line BL and a sidewall corresponding to the first electrode 21 or the first electrode dummy structure 31 are respectively exposed on the two opposite sides of the second accommodation groove in the first direction (e.g., the Y direction). That is, the second accommodation groove of the storage cell U1 may expose a sidewall of the corresponding first electrode 21, and the second accommodation groove of the selection cell U2 may expose a sidewall of the corresponding first electrode dummy structure 31.

In addition, the access transistor T1 of the storage cell U1 and the selection transistor T2 of the selection cell U2 each include a semiconductor layer 41 that conformally covers an inner sidewall of the corresponding second accommodation groove, and a gate insulating layer 42 that conformally covers the semiconductor layer 41 and the sidewall of the second hole. Correspondingly, the memory further includes a word line WL that covers the gate insulating layer 42 and fills the second hole in the storage cell U1, and a selection line SL that covers the gate insulating layer 42 and fills the second hole in the selection cell U2. The connection cell U3 further includes a second filling layer 34 that fills the second hole.

Here, the second filling layer 34 that fills the second hole may also be considered as a dummy line DL. That is, the dummy line DL, the selection line SL, and the word line WL may be arranged in sequence in the second direction (e.g., the X direction) and are sequentially away from the common bit line CBL.

For example, materials of the word line WL and the selection line SL include but are not limited to Indium-Tin-Oxide (ITO).

For example, the word line WL and the selection line SL are composed of substantially the same materials.

For example, the second filling layer 34 is an insulating material layer, for example, may be an aluminium oxide layer, but is not limited thereto.

For example, the diameters of the first hole H1 and the second hole H2 may be the same or different.

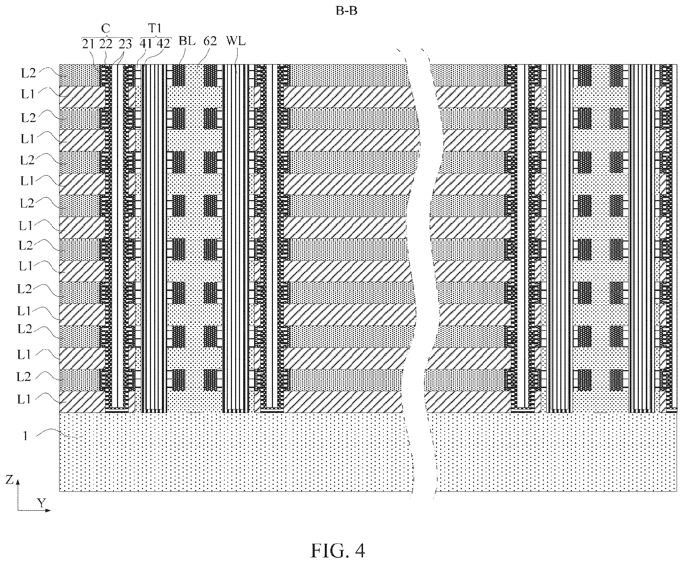

It should be added that, with reference to FIG. 1 and FIG. 4, in other embodiments of the present disclosure, the sidewall of the bit line BL and the sidewall of the corresponding first electrode 21 or the sidewall of the corresponding first electrode dummy structure 31 are respectively exposed on two opposite sides of the second hole of each cell in the cell array N in the first direction (e.g., the Y direction). In this way, the access transistor T1 and the selection transistor T2 each further include a semiconductor layer 41 and a gate insulating layer 42 that are formed on an inner sidewall of the second hole. Semiconductor layers 41 of adjacent access transistors T1 are insulated from each other in a direction (e.g., the Z direction) perpendicular to the substrate 1, and semiconductor layers 41 of adjacent selection transistors T2 are insulated from each other in a direction (e.g., the Z direction) perpendicular to the substrate 1. Correspondingly, the memory further includes a word line WL that covers the gate insulating layer 42 and fills the second hole in the storage cell U1, and a selection line SL that covers the gate insulating layer 42 and fills the second hole in the selection cell U2. The connection cell U3 further includes a second filling layer 34 (that is, a dummy line DL) that fills the second hole.

For example, with reference to FIG. 1 and FIG. 4, there are a plurality of bit lines BL, and the plurality of bit lines BL are insulated and arranged in a direction parallel to the substrate 1 and are insulated and stacked in a direction perpendicular to the substrate 1. Every two adjacent bit lines BL in the direction parallel to the substrate 1 form a bit line group. Cells corresponding to any bit line BL in the bit line group are located on a same side of the bit line BL that is away from the other bit line BL.

For example, two bit lines BL in a same bit line group may be formed by two side lines separated by each other in a ring-shaped conductive layer. Accordingly, the memory further includes a first isolation layer 61 (as shown in FIG. 3) or a second isolation layer 62 (as shown in FIG. 4) disposed between two adjacent bit lines BL in the bit line group. Refer to FIG. 4. In an example in which a second isolation layer 62 is disposed between two adjacent bit lines BL, semiconductor layers 41 of adjacent access transistors T1 in a direction (e.g., the Z direction) perpendicular to the substrate 1 and semiconductor layers 41 of adjacent selection transistors T2 in a direction (e.g., the Z direction) perpendicular to the substrate 1 may be insulated by an extended portion of the second isolation layer 62 in a direction parallel to the substrate 1.

For example, still referring to FIG. 1, the common bit line CBL may be a ring-shaped conductive layer. Correspondingly, the memory further includes a first isolation layer 61 disposed in an area within the common bit line CBL ring.

For example, the first isolation layer 61 includes but is not limited to a stacked structure with a silicon nitride layer 611 and an aluminium oxide layer 612.

For example, the second isolation layer 62 includes but is not limited to a stacked structure with a silicon nitride layer and a silicon oxide layer.

For example, the common bit line CBL and the bit line BL include but are not limited to a stacked structure with a titanium nitride layer and a tungsten metal layer.

In some embodiments of the present disclosure, as shown in FIG. 1, the bit line BL includes a first part BLa opposite to the storage cell U1 and the selection cell U2, and a second part BLb opposite to the connection cell U3. The second part BLb and the common bit line CBL may be integrated or spaced apart from each other. The memory further includes an isolation structure 5 located between the first part BLa and the second part BLb.

In some embodiments of the present disclosure, with reference to FIG. 1, one bit line BL corresponds to at least two connection cells U3. The isolation structure 5 includes a first isolation part that is located between the first part BLa and the second part BLb, and a second isolation part that includes at least a part of the second filling layer 34 (that is, the dummy line DL) and that is at least connected to the first isolation part. For example, the second isolation part may further extend to a sidewall of the first electrode dummy structure 31 in the connection cell U3. FIG. 1 is only a schematic diagram of the overall isolation structure 5, but does not identify the first isolation part and the second isolation part.

In some embodiments of the present disclosure, with reference to FIG. 1, there are a plurality of common bit lines CBL, and the plurality of common bit lines CBL are insulated and stacked in a direction (e.g., the Z direction) perpendicular to the substrate 1. The memory further includes a staircase structure S on a side of the common bit line CBL that is away from the bit line BL. The staircase structure S includes a plurality of conductive stairs that are correspondingly coupled to the common bit lines CBL.

For example, the staircase structure S further includes a plurality of insulating stairs that are alternately stacked with a plurality of conductive stairs.

It may be understood herein that the staircase structure S may be a single-sided or double-sided staircase. In addition, in an example in which the staircase structure S is a double-sided staircase, quantities of conductive stairs on the two sides are the same or different. For example, in the example in which the staircase structure S is a double-sided staircase, a conductive stair of one side of the staircase is coupled to a common bit line CBL at an odd layer, and a conductive stair of the other side is coupled to a common bit line CBL at an even layer.

For example, the memory further includes a barrier wall 81 on a side of the common bit line CBL that is away from the bit line BL. An area surrounded by the barrier wall 81 and the common bit line CBL is a setting area of the staircase structure S. The barrier wall 81 may be, for example, a silicon oxide barrier wall.

For example, the memory further includes a cover layer 82 that covers the stairs in the staircase structure S. The cover layer 82 may be, for example, a stacked structure with a first sub-layer 821 and a second sub-layer 822. The first sub-layer 821 includes but is not limited to an aluminium oxide layer, and the second sub-layer 822 includes but is not limited to a silicon oxide layer.

It should be noted that, with reference to FIG. 1, in some embodiments of the present disclosure, a plurality of first dielectric layers L1 and a plurality of second dielectric layers L2 may be alternately stacked on the substrate 1. The first dielectric layer L1 includes but is not limited to a silicon oxide layer, and the second dielectric layer L2 includes but is not limited to a silicon nitride layer. Correspondingly, each component of the memory may be formed in a corresponding hole or groove by first etching each first dielectric layer L1 and each second dielectric layer L2 to form the hole or groove.

Some embodiments of the present disclosure further provide a manufacturing method of a memory, which is used to manufacture the memory in the foregoing embodiments. The technical advantages of the foregoing memory are also present in the manufacturing method.

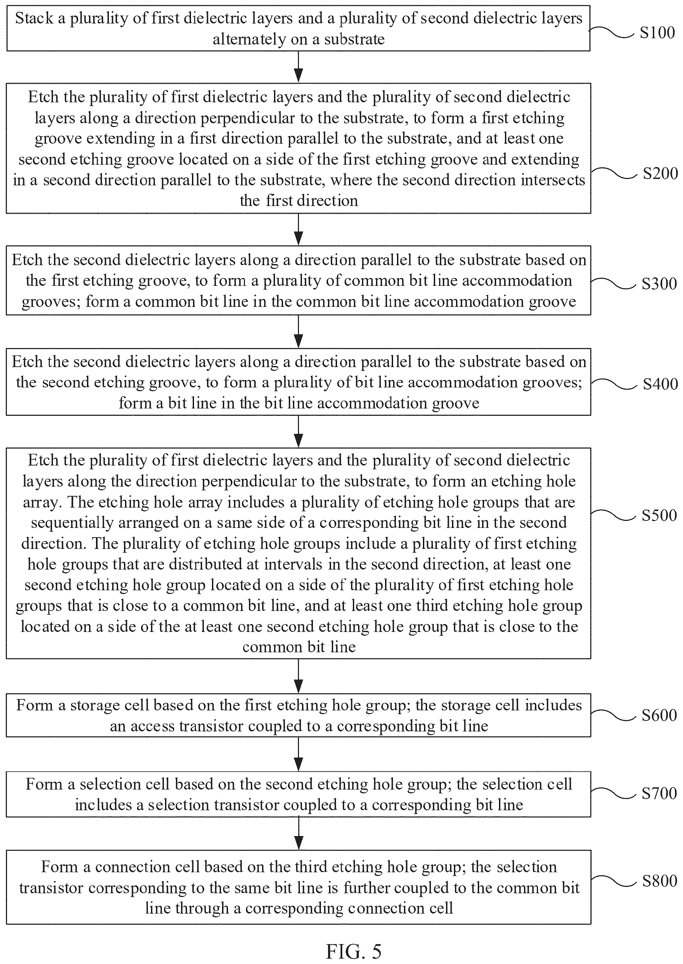

Refer to FIG. 5. The manufacturing method includes the following steps.

In step S100, a plurality of first dielectric layers and a plurality of second dielectric layers are alternately stacked on a substrate.

In step S200, the plurality of first dielectric layers and the plurality of second dielectric layers are etched along a direction perpendicular to the substrate, to form a first etching groove that extends in a first direction parallel to the substrate, and at least one second etching groove that is located on a side of the first etching groove and that extends in a second direction parallel to the substrate. The second direction intersects the first direction.

In step S300, the second dielectric layers are etched along a direction parallel to the substrate based on the first etching groove, to form a plurality of common bit line accommodation grooves. A common bit line is formed in the common bit line accommodation groove.

In step S400, the second dielectric layers are etched along a direction parallel to the substrate based on the second etching groove, to form a plurality of bit line accommodation grooves. A bit line is formed in the bit line accommodation groove.

In step S500, the plurality of first dielectric layers and the plurality of second dielectric layers are etched along the direction perpendicular to the substrate, to form an etching hole array. The etching hole array includes a plurality of etching hole groups that are sequentially arranged on a same side of a corresponding bit line in the second direction. The plurality of etching hole groups include a plurality of first etching hole groups that are distributed at intervals in the second direction, at least one second etching hole group that is located on a side of the plurality of first etching hole groups that is close to a common bit line, and at least one third etching hole group that is located on a side of the at least one second etching hole group that is close to the common bit line.

In step S600, a storage cell is formed based on the first etching hole group, and the storage cell includes an access transistor coupled to a corresponding bit line.

In step S700, a selection cell is formed based on the second etching hole group, and the selection cell includes a selection transistor coupled to a corresponding bit line.

In step S800, a connection cell is formed based on the third etching hole group, and the selection transistor corresponding to the same bit line is further coupled to the common bit line through a corresponding connection cell.

In some embodiments of the present disclosure, the etching hole array in step S500 may be formed before a common bit line accommodation groove and a bit line accommodation groove are formed. In addition, the first etching hole group, the second etching hole group, and the third etching hole group each include a first hole whose axis is perpendicular to the substrate.

Correspondingly, the manufacturing method of the memory further includes the following steps.

In step S510, each etching hole of the etching hole array is filled with a third dielectric layer.

In step S520, the third dielectric layer is removed from each first hole after the common bit line is formed.

In step S530, the second dielectric layer is etched along a direction parallel to the substrate based on the first hole, to form a first accommodation groove.

Correspondingly, the step S600 in which the storage cell is formed based on the first etching hole group includes the step as follows: A first electrode that conformally covers an inner sidewall of the first accommodation groove is formed, a dielectric layer that conformally covers the first electrode and the sidewall of the first hole is formed, and a second electrode that covers the dielectric layer and fills the first accommodation groove and the first hole is formed.

The step S700 in which the selection cell is formed based on the second etching hole group and the step S800 in which the connection cell is formed based on the third etching hole group both include step S710.

In step S710, a first electrode dummy structure that conformally covers the inner sidewall of the corresponding first accommodation groove is formed.

As described above, first electrode dummy structures in the selection cell and the connection cell corresponding to a same bit line are interconnected. A selection transistor in a selection cell is coupled to a first electrode dummy structure of the same selection cell. The first electrode dummy structure in the connection cell close to the common bit line is coupled to the common bit line.

In some embodiments of the present disclosure, step S700 in which the selection cell is formed based on the second etching hole group and step S800 in which the connection cell is formed based on the third etching hole group both further include S720 and S730.

In step S720, a support electrode that covers the first electrode dummy structure and fills the first accommodation groove is formed.

In step S730, a first filling layer that fills the first hole is formed.

In some embodiments of the present disclosure, the first etching hole group, the second etching hole group, and the third etching hole group each further include a second hole that is located between the bit line and the first hole and whose axis is perpendicular to the substrate.

Correspondingly, step S600 in which the storage cell is formed based on the first etching hole group and step S700 in which the selection cell is formed based on the second etching hole group each include the following steps S610 to S640.

In step S610, the third dielectric layer is removed from the second hole.

In step S620, the second dielectric layer is etched along a direction parallel to the substrate based on the second hole, to form a second accommodation groove. A sidewall of the bit line and a sidewall corresponding to the first electrode or the first electrode dummy structure are respectively exposed on the two opposite sides of the second accommodation groove in the first direction.

In step S630, a semiconductor layer conformally covering an inner sidewall of the corresponding second accommodation groove is formed.

In step S640, a gate insulating layer conformally covering the semiconductor layer and a sidewall of the second hole is formed.

Correspondingly, the manufacturing method of the memory further includes step S650.

In step S650, a word line that covers the gate insulating layer and fills the second hole in the storage cell is formed, and a selection line that covers the gate insulating layer and fills the second hole in the selection cell is formed.

In other embodiments of the present disclosure, the manufacturing method of the memory further includes the following step: The first etching groove and the second etching groove are filled with a first isolation layer before the memory cell, the selection cell, and the connection cell are formed.

In addition, the first etching hole group, the second etching hole group, and the third etching hole group each further include a second hole that is located between the bit line and the first hole and whose axis is perpendicular to the substrate. A sidewall of the bit line and a sidewall corresponding to the first electrode or the first electrode dummy structure are respectively exposed on the two opposite sides of the second hole in the first direction. Correspondingly, step S600 in which the storage cell is formed based on the first etching hole group and step S700 in which the selection cell is formed based on the second etching hole group each include the following steps S610' to S670'.

In step S610', the third dielectric layer is removed from the second hole.

In step S620', an initial semiconductor layer and a gate insulating layer are sequentially formed on an inner sidewall of the second hole.

In step S630', a word line that covers the gate insulating layer and fills the second hole in the storage cell is formed, and a selection line that covers the gate insulating layer and fills the second hole in the selection cell is formed.

In step S640', the first isolation layer is removed from the second etching groove.

In step S650', the first dielectric layers are etched along the first direction until a sidewall of the initial semiconductor layer that is away from the gate insulating layer is exposed.

In step S660', the initial semiconductor layer between any adjacent second dielectric layers are etched and removed to form a plurality of semiconductor layers disposed at intervals in a direction perpendicular to the substrate.

In step S670', a second isolation layer filling a spacing between the adjacent semiconductor layers, a region with the first dielectric layer being removed, and the second etching groove is formed.

In some embodiments of the present disclosure, one bit line corresponds to at least two connection cells. Step S400 in which the bit line is formed in the bit line accommodation groove includes the following steps S410 to S430.

In step S410, an initial bit line is formed in the bit line accommodation groove.

In step S420, the third dielectric layer in the second hole in any third etching hole group is removed after the storage cell, the selection cell, and the connection cell are formed, and the initial bit line is etched and cut off in a direction parallel to the substrate based on the second hole, to form the bit line. The bit line includes a first part opposite to the storage cell and the selection cell, and a second part opposite to the connection cell.

In step S430, an isolation structure is formed in the cut-off region of the initial bit line and the second hole connected thereto.

In some embodiments of the present disclosure, an end of the bit line accommodation groove close to the common bit line accommodation groove is connected to the common bit line accommodation groove. The common bit line and the initial bit line are simultaneously formed. The second part of the bit line and the common bit line may be an integrated structure.

In some embodiments of the present disclosure, after the common bit line and the initial bit line are formed, and before the storage cell, the selection cell, and the connection cell are formed, the manufacturing method of the memory further includes the following steps S401 to S405.

In step S401, the plurality of first dielectric layers and the plurality of second dielectric layers are etched along the direction perpendicular to the substrate, and a third etching groove is formed on a side of the common bit line that is away from the initial bit line.

In step S402, the first dielectric layers are etched based on the third etching groove, to form a plurality of insulating stairs.

In step S403, the second dielectric layers are etched based on the third etching groove, to form a plurality of conductive stair accommodation grooves; and a sidewall corresponding to the common bit line is exposed by the conductive stair accommodation groove.

In step S404, a conductive stair coupled to the common bit line is formed in the conductive stair accommodation groove. The conductive stairs and the insulating stairs jointly form a staircase structure.

In step S405, a cover layer covering the staircase structure is formed.

In the foregoing embodiments of the present disclosure, unless expressly described in this specification, the steps in the foregoing method are not performed in a strict order. These steps may not necessarily be performed in the described order, and may be performed in another execution manner. In addition, at least some steps in the foregoing steps may include a plurality of sub-steps or phases. These sub-steps or phases are not necessarily performed and completed at the same moment, but may be performed at different moments. These sub-steps or phases are not necessarily sequentially performed, but may be performed in turn or alternately with another step or at least some of the sub-steps or phases in the another step.

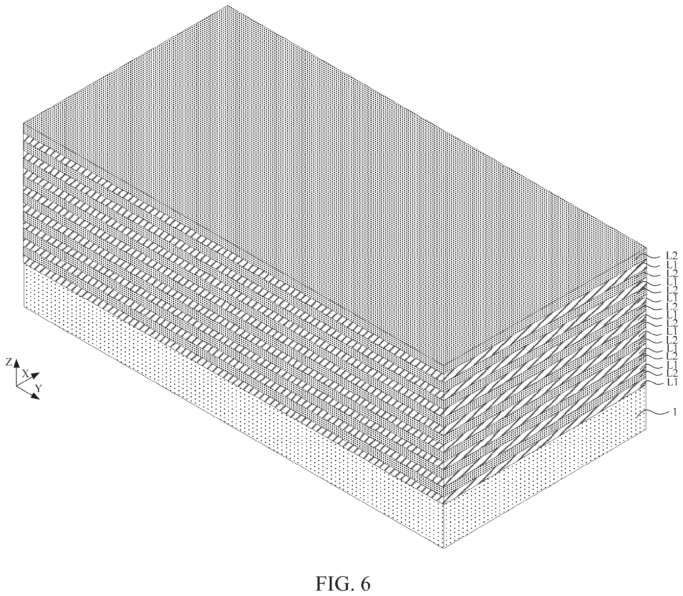

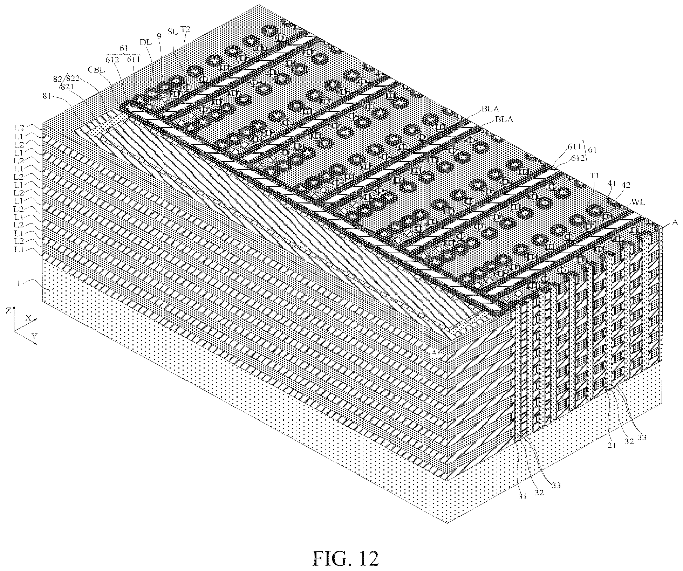

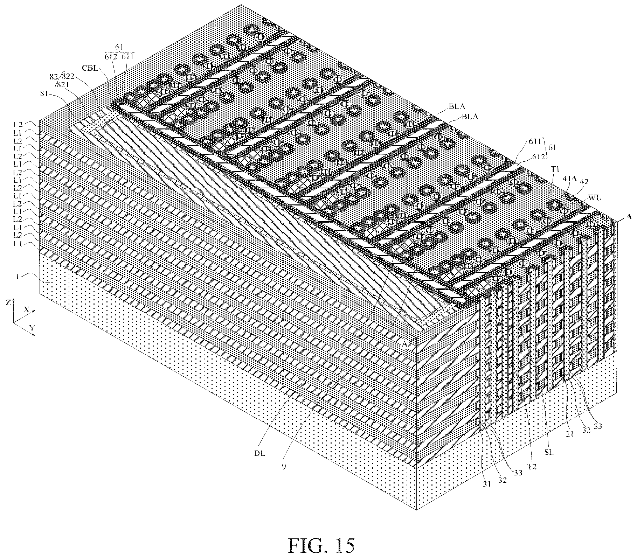

To describe the manufacturing method of the memory in the foregoing embodiments more clearly, the following embodiments describe some manufacturing methods of the memory in detail with reference to FIG. 6 to FIG. 17.

In step S100, as shown in FIG. 6, a plurality of first dielectric layers L1 and a plurality of second dielectric layers L2 are alternately stacked on the substrate 1.

For example, the first dielectric layer L1 includes but is not limited to a silicon oxide layer. The second dielectric layer L2 includes but is not limited to a silicon nitride layer.

For example, the substrate 1 may be formed by a semiconductor material, an insulating material, a conductor material, or any combination thereof. The substrate 1 may be a single-layer structure, or may be a multi-layer structure. For example, the substrate 1 may be a silicon (Si) substrate, a silicon germanium (SiGe) substrate, a silicon germanium carbon (SiGeC) substrate, a silicon carbide (SiC) substrate, a gallium arsenide (GaAs) substrate, an indium arsenide (InAs) substrate, an indium phosphide (InP) substrate, or another III/V semiconductor substrate or II/VI semiconductor substrate. Alternatively, for another example, the substrate 1 may be a layered substrate including Si/SiGe, Si/SiC, silicon on insulator (SOI), or silicon germanium on insulator.

For example, a quantity of stack layers of the first dielectric layers L1 and the second dielectric layers L2 may be selected and set according to a requirement. In addition, alternately stacking of the first dielectric layers L1 and the second dielectric layers L2 may start from the first dielectric layer L1 and end with the first dielectric layer L1. The following embodiments of the present disclosure are described in detail with this example, but are not limited thereto. For example, the stacking may start from the second dielectric layer L2 and end with the first dielectric layer L1.

For example, a forming process of the first dielectric layer L1 and the second dielectric layer L2 includes but is not limited to a chemical vapor deposition process.

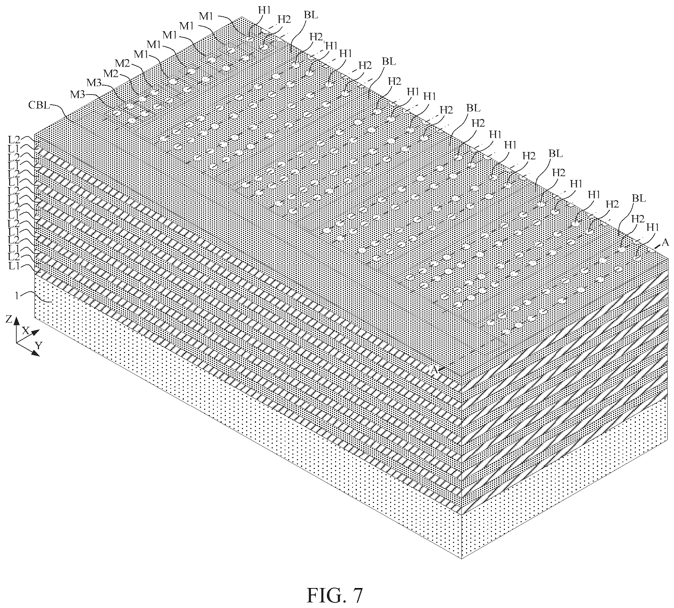

In step S500, as shown in FIG. 7, each first dielectric layer L1 and each second dielectric layer L2 are etched along a direction (e.g., the Z direction) perpendicular to the substrate to form an etching hole array. The etching hole array includes a plurality of etching hole groups that are sequentially arranged on a same side of a corresponding bit line BL in the second direction (e.g., the X direction). The plurality of etching hole groups include a plurality of first etching hole groups M1 that are distributed at intervals in the second direction (e.g., the X direction), at least one second etching hole group M2 that is located on a side of the plurality of first etching hole groups M1 that is close to the common bit line CBL, and at least one third etching hole group M3 that is located on a side of the at least one second etching hole group M2 that is close to the common bit line CBL.

Herein, the first etching hole group M1 may be configured to prepare a storage cell, the second etching hole group M2 may be configured to prepare a selection cell, and the third etching hole group M3 may be configured to prepare a connection cell.

It may be understood that, when the etching hole array is formed, the bit line BL and the common bit line CBL are not formed. In FIG. 7, to-be-formed areas of the bit line BL and the common bit line CBL are identified, so as to clearly describe a distribution location of each etching hole.

For example, the first etching hole group M1, the second etching hole group M2, and the third etching hole group M3 are located on a same side of the corresponding bit line BL that extends in the second direction (e.g., the X direction) and are sequentially distributed in the second direction (e.g., the X direction) in a direction close to the common bit line CBL.

For example, the first etching hole group M1, the second etching hole group M2, and the third etching hole group M3 each include a first hole H1 whose axis is perpendicular to the substrate and a second hole H2 that is located between a bit line BL and the first hole H1 and whose axis is perpendicular to the substrate 1.

For example, the diameters of the first hole H1 and the second hole H2 may be the same or different.

For example, the adjacent third etching hole groups M3 in the second direction (e.g., the X direction) and the adjacent second etching hole groups M2 may be disposed without an interval or with relatively small intervals. For example, the interval between adjacent third etching hole groups M3 in the second direction (e.g., the X direction) and the interval between adjacent second etching hole groups M2 in the second direction (e.g., the X direction) are less than the interval between adjacent first etching hole groups M1 in the second direction (e.g., the X direction).

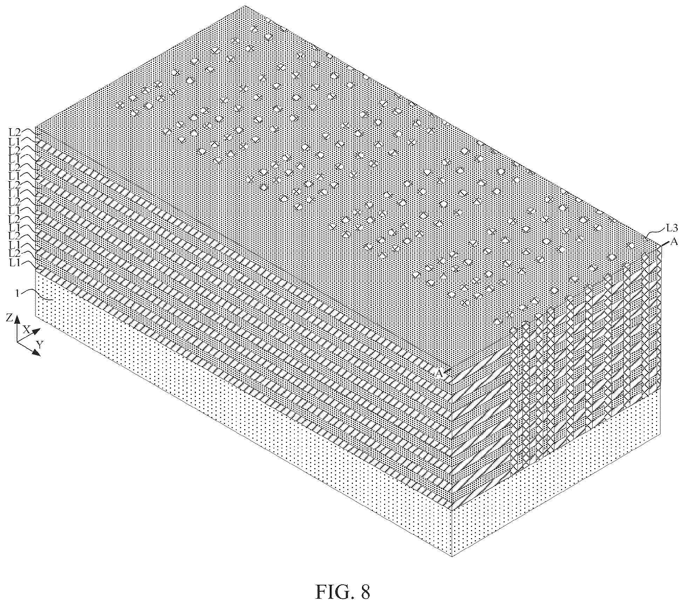

In step S510, as shown in FIG. 8, each etching hole of the etching hole array is filled with the third dielectric layer L3.

For example, a material of the third dielectric layer L3 is different from those of the first dielectric layer L1 and the second dielectric layer L2. For example, the third dielectric layer L3 includes but is not limited to an aluminium oxide layer.

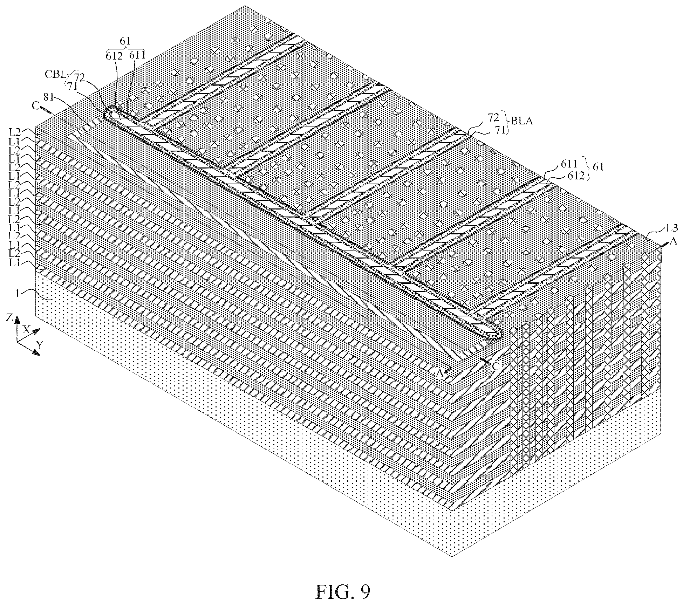

In step S200, with reference to FIG. 9, the first dielectric layers L1 and the second dielectric layers L2 are etched along a direction (e.g., the Z direction) perpendicular to the substrate 1, to form a first etching groove extending in the first direction (e.g., the Y direction) parallel to the substrate 1, and at least one second etching groove located on a side of the first etching groove and extending in the second direction (e.g., the X direction) parallel to the substrate 1. The second direction (e.g., the X direction) intersects, for example, is orthogonal to, the first direction (e.g., the Y direction).

It may be understood that although the first etching groove and the second etching groove are not identified in FIG. 9, the first etching groove is an area within a ring of the subsequently formed common bit line CBL, and the second etching groove is a spacing area between every two adjacent bit lines BL subsequently formed. In addition, the first etching groove and the second etching groove may penetrate the first dielectric layers L1 and the second dielectric layers L2, so as to expose a surface of the substrate 1.

In steps S300 and S400, with reference to FIG. 9, a plurality of common bit line accommodation grooves may be formed by etching the second dielectric layers L2 in a direction parallel to the substrate 1 based on the first etching groove, so as to form a common bit line CBL in the common bit line accommodation groove; and a plurality of bit line accommodation grooves may be formed by etching the second dielectric layers L2 in a direction parallel to the substrate 1 based on the second etching groove, so as to form a bit line BL in the bit line accommodation groove.

It may be understood herein that a coupling relationship between the initial bit line BLA and the common bit line CBL is matched, and an end of the bit line accommodation groove that is close to the common bit line accommodation groove may be connected to or disposed at intervals with the common bit line accommodation groove.

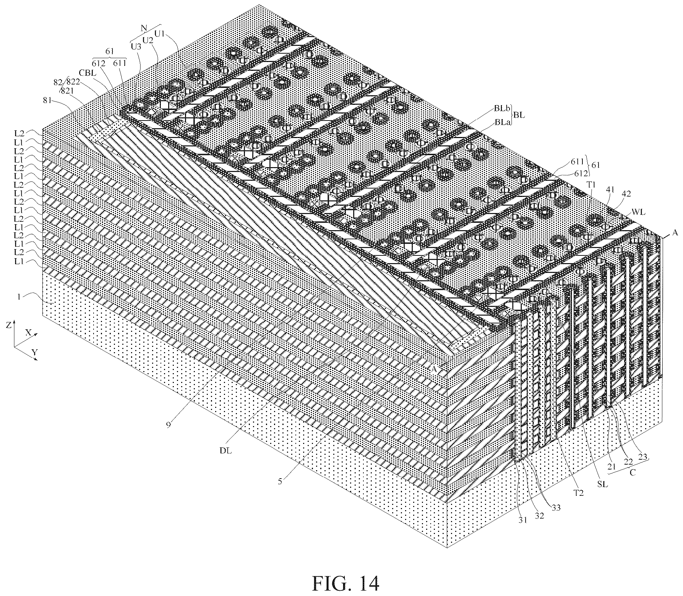

In some embodiments, the end of the bit line accommodation groove that is close to the common bit line accommodation groove is connected to the common bit line accommodation groove. The bit line BL may be obtained in such a manner that the initial bit line BLA (e.g., shown in FIG. 9) is first formed in the bit line accommodation groove and then the initial bit line BLA is cut off (e.g., shown in FIG. 14).

For example, the first etching groove and the second etching groove may be formed by a dry etching process. The bit line accommodation groove and the common bit line accommodation groove may be formed by a wet etching process.

For example, the common bit line accommodation groove is ring-shaped. Bit line accommodation grooves corresponding to every two adjacent initial bit lines BLA may be connected in a ring shape.

For example, the initial bit line BLA and the common bit line CBL may be simultaneously formed, and a single-layer conductive layer or stacked conductive layers are used. For example, the initial bit line BLA and the common bit line CBL each are a stacked structure with a titanium nitride layer 71 and a tungsten metal layer 72.

For example, as shown in FIG. 9, before the storage cell U1, the selection cell U2, and the connection cell U3 are formed, the first etching groove and the second etching groove are filled with the first isolation layer 61.

For example, the first isolation layer 61 may be a single-layer insulating layer or a stacked insulating layer. For example, the first isolation layer 61 includes but is not limited to a stack of a silicon nitride layer 611 and an aluminium oxide layer 612.

In some embodiments of the present disclosure, as shown in FIG. 9, the manufacturing method of the memory further includes the step as follows: A barrier wall 81 is formed on a side of the common bit line CBL that is away from the bit line BL, so as to form a staircase structure S on an area surrounded by the barrier wall 81 and the common bit line CBL. The barrier wall 81 may be, for example, a silicon oxide barrier wall.

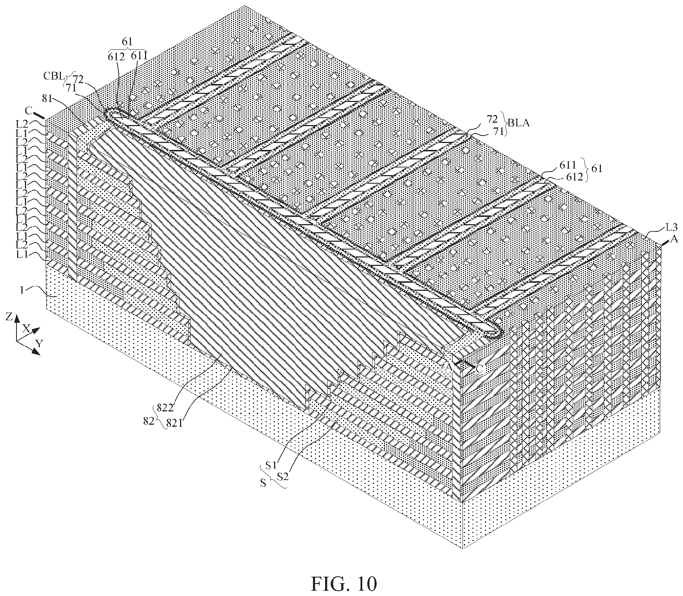

For example, as shown in FIG. 10, after the common bit line CBL and the initial bit line BLA are formed and before the storage cell U1, the selection cell U2, and the connection cell U3 are formed, the manufacturing method of the memory further includes the following steps S401 to S405.

In step S401, the first dielectric layers L1 and the second dielectric layers L2 are etched along a direction (e.g., the Z direction) perpendicular to the substrate 1, to form a third etching groove on a side of the common bit line CBL that is away from the initial bit line BLA.

For example, the third etching groove may be formed by a dry etching process.

In step S402, the first dielectric layers L1 are etched based on the third etching groove to form a plurality of insulating stairs S1.

In step S403, the second dielectric layers L2 are etched based on the third etching groove, to form a plurality of conductive stair accommodation grooves. The conductive stair accommodation groove exposes a sidewall corresponding to the common bit line CBL.

For example, the conductive stair accommodation groove may be formed by a wet etching process.

In step S404, a conductive stair S2 coupled to the common bit line CBL is formed in the conductive stair accommodation groove. The conductive stairs S2 and the insulating stairs S1 jointly form a staircase structure S.

For example, the conductive stair S2 includes but is not limited to a tungsten metal layer.

In step S405, a cover layer 82 that covers the staircase structure S is formed.

For example, the cover layer 82 may be, for example, a stacked structure with a first sub-layer 821 and a second sub-layer 822. The first sub-layer 821 includes but is not limited to an aluminium oxide layer, and the second sub-layer 822 includes but is not limited to a silicon oxide layer.

The foregoing embodiment provides an example manner of forming a staircase structure S. However, a manner of forming the staircase structure S is not limited thereto. Any other method that can be used to prepare the staircase structure is also applicable to the present disclosure.

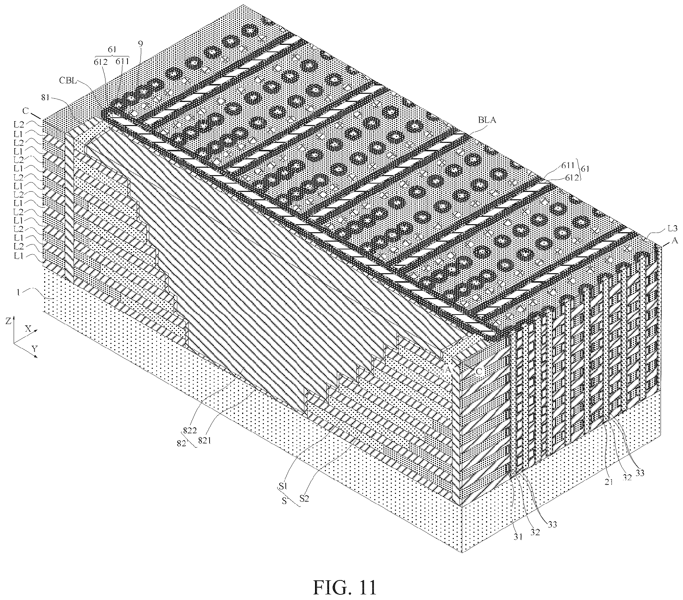

In step S520, with reference to FIG. 11, after the common bit line CBL is formed, the third dielectric layer L3 in each first hole H1 is removed.

For example, the third dielectric layer L3 in the first hole H1 may be removed by a dry etching process.

In step S530, with reference to FIG. 11, the second dielectric layer L2 is etched along a direction parallel to the substrate 1 based on the first hole H1, to form a first accommodation groove.

For example, the first accommodation groove may be formed by a wet etching process.

In steps S600, S700, and S800, with reference to FIG. 11 to FIG. 14, a storage cell U1 is formed based on the first etching hole group M1, a selection cell U2 is formed based on the second etching hole group M2, and a connection cell U3 is formed based on the third etching hole group M3.

Herein, for a structure of the storage cell U1, the selection cell U2, and the connection cell U3, refer to related descriptions in the foregoing embodiments, and details are not described again. In addition, the storage cell U1, the selection cell U2, and the connection cell U3 interact with each other in a manufacturing process. For example, the access transistor T1 of the storage cell U1 and the selection transistor T2 of the selection cell U2 may be simultaneously prepared.

For example, as shown in FIG. 11, in step S710, after the first accommodation groove is formed, the first electrode 21 may conformally cover an inner sidewall of the first accommodation groove corresponding to the first etching hole group M1, and first electrode dummy structures 31 conformally cover inner sidewalls of first accommodation grooves corresponding to the second etching hole group M2 and the third etching hole group M3 simultaneously. The first electrode dummy structures 31 in the selection cell U2 and the connection cell U3 corresponding to the same bit line BL are interconnected, so as to form a connection electrode 9. In addition, the first electrode dummy structure 31 in the connection cell U3 close to the common bit line CBL is coupled to the common bit line CBL.

For example, the first electrode 21 and the first electrode dummy structure 31 may be formed by a same material through an atomic layer deposition process.

In step S720, a support electrode 32 that covers the first electrode dummy structure 31 and fills the first accommodation grooves corresponding to the second etching hole group M2 and the third etching hole group M3. In addition, a support electrode 32 that covers the first electrode 21 and fills the first accommodation groove corresponding to the first etching hole group M1 may also be simultaneously formed.

For example, the support electrode 32 includes but is not limited to a polysilicon layer.

In step S730, a first filling layer 33 that fills each first hole H1 is formed.

For example, the first filling layer 33 is a stacked structure with a silicon nitride layer and a silicon oxide layer.

It may be understood that in other embodiments, the first electrode dummy structures 31 formed in the selection cell U2 and the connection cell U3 may fill the first accommodation grooves. Correspondingly, forming the selection cell U2 and forming the connection cell U3 each further include the step as follows: A first filling layer 33 that fills the first hole is formed. The connection electrode 9 may be formed only by connecting the first electrode dummy structures 31 in the selection cell U2 and the connection cell U3.

It should be noted that there may be a plurality of possible implementations of the access transistor T1 of the storage cell U1 and the selection transistor T2 of the selection cell U2 to match the diameter of the second hole H2 in the etching hole group.

In some possible implementations, with reference to FIG. 3, FIG. 12, and FIG. 13, step S600 in which the storage cell U1 is formed based on the first etching hole group M1 and step S700 in which the selection cell U2 is formed based on the second etching hole group M2 each include the following steps S610 to S640.

In step S610, the third dielectric layer L3 in the second hole H2 in each first etching hole group M1 and each second etching hole group M2 is removed, for example, may be removed by a dry etching process or a wet etching process.

In this case, the third dielectric layer L3 in the second hole H2 in the third etching hole group M3 forms the second filling layer 34 in the second hole H2 in the connection cell U3, or may be considered as an dummy line DL.

In step S620, the second dielectric layer L2 is etched along the direction parallel to the substrate 1 based on the second holes H2 in each first etching hole group M1 and each second etching hole group M2, to form a second accommodation groove. A sidewall of the bit line BL and a sidewall corresponding to the first electrode 21 are respectively exposed on opposite sides of the second accommodation groove corresponding to the first etching hole group M1 in the first direction (e.g., the Y direction), and a sidewall of the bit line BL and a sidewall corresponding to the first electrode dummy structure 31 are respectively exposed on opposite sides of the second accommodation groove corresponding to the second etching hole group M2 in the first direction (e.g., the Y direction).

For example, the second accommodation groove may be formed by a wet etching process.

In step S630, a semiconductor layer 41 conformally covering an inner sidewall of the corresponding second accommodation groove is formed. The semiconductor layer 41 of the access transistor T1 in a storage cell U1 is connected to and in contact with the first electrode 21 of the same storage cell. The semiconductor layer 41 of the selection transistor T2 in a selection cell U2 is connected to and in contact with the first electrode dummy structure 31 of the same selection cell.

For example, the semiconductor layer 41 includes but is not limited to a metal oxide layer, for example, may be an indium gallium zinc oxide (IGZO) layer.

For example, the semiconductor layer 41 may be formed by an atomic layer deposition process.

In step S640, a gate insulating layer 42 conformally covering the semiconductor layer 41 and a sidewall of the second hole H2 is formed.

In step S650, a word line WL that covers the gate insulating layer 42 and fills the second hole H2 in the storage cell U1 is formed, and a selection line SL that covers the gate insulating layer 42 and fills the second hole H2 in the selection cell U2 is formed.

For example, the word line WL and the selection line SL are simultaneously formed by the same material, for example, by ITO.

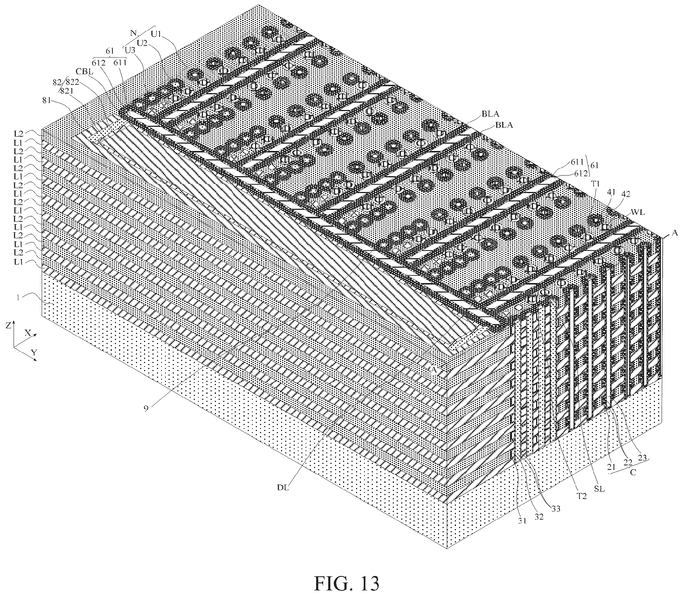

For example, as shown in FIG. 13, after the word line WL and the selection line SL are formed, the first filling layer 33 in the first hole H1 in the first etching hole group M1 and the support electrode 32 in the corresponding first accommodation groove may be removed, so as to expose the first electrode 21. Then, a dielectric layer 22 that conformally covers the first electrode 21 and the sidewall of the first hole H1, and a second electrode 23 that covers the dielectric layer 22 and fills the first accommodation groove and the first hole H1 are formed, so as to prepare and obtain a capacitor C.

For example, as shown in FIG. 14, one bit line BL corresponds to at least two connection cells U3. Step S400 in which the bit line BL is formed in the bit line accommodation groove includes the following steps S410 to S430.

In step S410, as shown in FIG. 9 to FIG. 13, an initial bit line BLA is formed in the bit line accommodation groove.

In step S420, as shown in FIG. 14, after the storage cell U1, the selection cell U2, and the connection cell U3 are formed, the third dielectric layer L3 (that is, the second filling layer 34) in the second hole H2 in any third etching hole group M3 is removed, and an initial bit line BLA is etched and cut off in a direction parallel to the substrate 1 based on the second hole H2, to form a bit line BL. The bit line BL includes a first part BLa opposite to the storage cell U1 and the selection cell U2, and a second part BLb opposite to the connection cell U3.

For example, the second part BLb of the bit line BL and the common bit line CBL are an integrated structure.

In step S430, as shown in FIG. 14, an isolation structure 5 is formed in the cut-off region of the initial bit line BLA and the second hole H2 connected thereto.

For example, the isolation structure 5 is formed by an insulating material, including but not limited to a silicon oxide layer.

In another possible implementation, with reference to FIG. 4, FIG. 15, and FIG. 16, a sidewall of the bit line BL and a sidewall corresponding to the first electrode 21 or the first electrode dummy structure 31 are respectively exposed on the two opposite sides of the second hole H2 in the first direction (e.g., the Y direction). Correspondingly, step S600 in which the storage cell U1 is formed based on the first etching hole group M1 and step S700 in which the selection cell U2 is formed based on the second etching hole group M2 each include the following steps S610' to S670'.

In step S610', the third dielectric layer L3 in the second hole H2 in each first etching hole group M1 and each second etching hole group M2 is removed, for example, may be removed by a dry etching process or a wet etching process.

In step S620', an initial semiconductor layer 41A and a gate insulating layer 42 are sequentially formed on an inner wall of the second hole H2 in each first etching hole group M1 and each second etching hole group M2.

In step S630', a word line WL that covers the gate insulating layer 42 and fills the second hole H2 in the storage cell U1 is formed, and a selection line SL that covers the gate insulating layer 42 and fills the second hole H2 in the selection cell U2 is formed.

In step S640', the first isolation layer 61 in the second etching groove is removed.

In step S650', the first dielectric layers L1 are etched along the first direction (e.g., the Y direction) until a sidewall of the initial semiconductor layer 41A that is away from the gate insulating layer 42 is exposed.

In step S660', an initial semiconductor layer 41A between any adjacent second dielectric layers L2 is etched and removed, to form a plurality of semiconductor layers 41 spaced apart in a direction (e.g., the Z direction) perpendicular to the substrate 1.

In step S670', a second isolation layer 62 filling a spacing between the adjacent semiconductor layers 41, a region with the first dielectric layer L1 being removed, and the second etching groove is formed.

For example, the second isolation layer 62 includes but is not limited to a stacked structure with a silicon nitride layer and a silicon oxide layer.

In this way, the semiconductor layer 41 of the access transistor T1 in a storage cell U1 is connected to and in contact with the first electrode 21 of the same storage cell, and the semiconductor layers 41 of adjacent access transistors T1 in a direction (e.g., the Z direction) perpendicular to the substrate 1 are insulated from each other by the extension portion of the second isolation layer 62 along a direction parallel to the substrate 1. The semiconductor layer 41 of the selection transistor T2 in a selection cell U2 is connected to and in contact with the first electrode dummy structure 31 of the same selection cell, and the semiconductor layers 41 of adjacent selection transistors T2 in a direction (e.g., the Z direction) perpendicular to the substrate 1 are insulated from each other by the extension portion of the second isolation layer 62 along a direction parallel to the substrate 1.

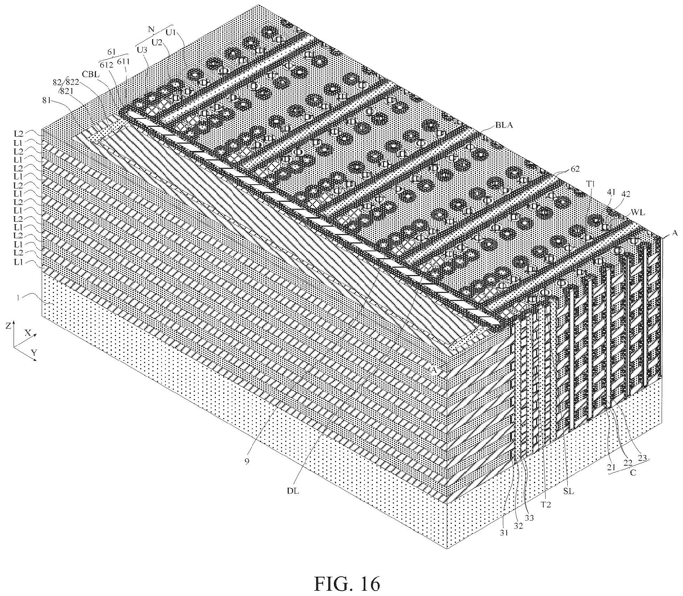

For example, as shown in FIG. 16, after the word line WL and the selection line SL are formed, the first filling layer 33 in the first hole H1 in the first etching hole group M1 and the support electrode 32 in the corresponding first accommodation groove may be removed, so as to expose the first electrode 21. Then, a dielectric layer 22 that conformally covers the first electrode 21 and the sidewall of the first hole H1, and a second electrode 23 that covers the dielectric layer 22 and fills the first accommodation groove and the first hole H1 are formed, so as to prepare and obtain a capacitor C.

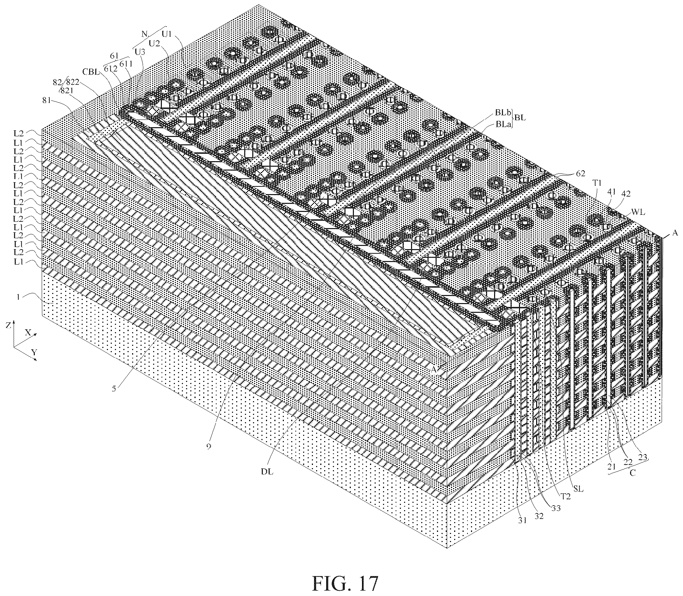

For example, as shown in FIG. 17, one bit line BL corresponds to at least two connection cells U3. Step S400 in which the bit line BL is formed in the bit line accommodation groove includes the following steps S410 to S430.

In step S410, as shown in FIG. 9 to FIG. 13, an initial bit line BLA is formed in the bit line accommodation groove.

In step S420, as shown in FIG. 17, after the storage cell U1, the selection cell U2, and the connection cell U3 are formed, the third dielectric layer L3 (that is, the second filling layer 34) in the second hole H2 in any third etching hole group M3 is removed, and an initial bit line BLA is etched and cut off in a direction parallel to the substrate 1 based on the second hole H2, to form a bit line BL. The bit line BL includes a first part BLa opposite to the storage cell U1 and the selection cell U2, and a second part BLb opposite to the connection cell U3.

For example, the second part BLb of the bit line BL and the common bit line CBL are an integrated structure.

In step S430, as shown in FIG. 17, an isolation structure 5 is formed in the cut-off region of the initial bit line BLA and the second hole H2 connected thereto.

Refer to FIG. 14 and FIG. 17. Some embodiments of the present disclosure further provide a memory, including a common bit line CBL, a bit line BL, a dummy line DL, a selection line SL, a word line WL, an access transistor T1, a capacitor C, and a selection transistor T2. The common bit line CBL extends in a first direction (e.g., the Y direction) parallel to the substrate 1. The bit line BL is located on a first side of the common bit line CBL and extends in a second direction (e.g., the X direction) parallel to the substrate 1. The second direction (e.g., the X direction) intersects, for example, is orthogonal to, the first direction (e.g., the Y direction).

Still refer to FIG. 14 and FIG. 17. The dummy line DL, the selection line SL, and the word line WL are all located on the first side of the common bit line CBL and all located on a same side of the bit line BL, and extend in a third direction (e.g., the Z direction) perpendicular to the substrate 1. The dummy line DL, the selection line SL, and the word line WL are arranged in the second direction (e.g., the X direction) in sequence and are away from the common bit line CBL in sequence. The access transistor T1 is coupled to the word line WL and the bit line BL. The capacitor C is located on a side of the access transistor T1 that is away from the bit line BL, and is coupled to the access transistor T1. The selection transistor T2 is coupled to the selection line SL, the bit line BL, and the common bit line CBL.

For example, the access transistor T1 is disposed around the word line WL. The selection transistor T2 is disposed around the selection line SL.

For example, the word line WL and the selection line SL are conductive wires, for example, may be formed by ITO. The dummy line DL is an insulation line, for example, may be formed by a high K dielectric material, for example, formed by aluminium oxide.

For example, the word line WL, the selection line SL, and the dummy line DL have the same or similar orthographic projection shapes on the substrate 1. In addition, the at least one dummy line DL, the at least one selection line SL, and the plurality of word lines WL are arranged in a second direction (e.g., the X direction) along a direction away from the common bit line CBL.

In addition, for structures of the access transistor T1, the selection transistor T2, the capacitor C, the bit line BL, the common bit line CBL, and other film layer in the memory, refer to related descriptions in the foregoing embodiments. Details are not described herein again. The memory also has the technical advantages of the foregoing memory.

In some embodiments of the present disclosure, as shown in FIG. 14 and FIG. 17, the memory further includes a connection electrode 9. The connection electrode 9 is located between the capacitor C and the common bit line CBL. The selection transistor T2 is coupled to the common bit line CBL through the connection electrode 9.

For example, the connection electrode 9 includes at least two first electrode dummy structures 31 that are coupled. At least one first electrode dummy structure 31 is located on a side of the selection transistor T2 that is away from the bit line BL and is connected to and in contact with the semiconductor layer 41 of the selection transistor T2. At least one first electrode dummy structure 31 is located on a side of the dummy line DL that is away from the bit line BL.

For example, the first electrode dummy structure 31 and the first electrode 21 of the capacitor C are simultaneously formed with a same material.

For example, the connection electrode 9 may further include a support electrode 32 that is connected to and in contact with the first electrode dummy structure 31.

Some embodiments of the present disclosure further provide an electronic device, such as a data storage device, a photocopier, a network device, a home appliance, an instrumentation, a mobile phone, a computer, and a device that has a data storage function. The electronic device may include the memory described in the foregoing embodiments and a processor coupled to the memory. For a structure of the memory, refer to related descriptions in the foregoing embodiments. The processor can control a read/write operation of the memory. The electronic device may further include another necessary component or component. This is not limited in this embodiment of the present disclosure.

For example, the electronic device may include a housing and a circuit board disposed in the housing. The memory and the processor may be integrated on the circuit board.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in the specification.

The foregoing embodiments represent only several implementations of the present disclosure, and descriptions thereof are relatively specific and detailed, but should not be construed as limitations on the patent scope of this application. It should be noted that, a person of ordinary skill in the art can further make several variations and improvements without departing from the concept of the present disclosure, all of which shall fall within the protection scope of the present disclosure. Therefore, the patent protection scope of the present disclosure shall be subject to the appended claims.

## Claims

1. A memory, comprising:
a common bit line (CBL), extending in a first direction (Y) parallel to a substrate (1);
a bit line (BL), located on a first side of the common bit line and extending in a second direction (X) parallel to the substrate, wherein the second direction intersects the first direction; and
a cell array (N), comprising a plurality of cells (U1, U2, U3) corresponding to the bit line, wherein the plurality of cells are located on a same side of the bit line and are arranged in sequence in the second direction;
wherein the plurality of cells include at least one connection cell (U3), at least one selection cell (U2) located on a side of the at least one connection cell that is away from the common bit line, and a plurality of storage cells (U1) located on a side of the at least one selection cell that is away from the common bit line; the storage cell and the selection cell each comprise a transistor coupled to the bit line; and the transistor comprised in the selection cell is a selection transistor (T2), and the selection transistor is further coupled to the common bit line through the connection cell.

2. The memory according to claim 1, wherein the transistor comprised in the storage cell is an access transistor (T1); and the storage cell further comprises a capacitor (C) comprising a first electrode (21) coupled to the access transistor, a second electrode (23) disposed opposite to the first electrode, and a dielectric layer (22) located between the first electrode and the second electrode;
the selection cell and the connection cell each comprise a first electrode dummy structure (31); and
the first electrode dummy structures in the selection cell and the connection cell corresponding to the bit line are interconnected; the selection transistor in the selection cell is coupled to the first electrode dummy structure of the selection cell; and the first electrode dummy structure in the connection cell close to the common bit line is coupled to the common bit line.

3. The memory according to claim 2, wherein each of the cells comprises a first hole (H1) whose axis is perpendicular to the substrate and a first accommodation groove extending in a direction parallel to the substrate and located on a sidewall of the first hole;
the first electrode and the first electrode dummy structure each conformally cover an inner sidewall of the corresponding first accommodation groove; the dielectric layer conformally covers the first electrode and a sidewall of the first hole; and the second electrode covers the dielectric layer and fills the first accommodation groove and the first hole; and
the selection cell and the connection cell each further comprise a support electrode (32) covering the first electrode dummy structure and filling the first accommodation groove, and a first filling layer (33) filling the first hole.

4. The memory according to claim 3, wherein each of the cells further comprises a second hole (H2) that is located between the bit line and the first hole and whose axis is perpendicular to the substrate; and
the storage cell and the selection cell each further comprise a second accommodation groove extending in a direction parallel to the substrate and located on a sidewall of the second hole; and a sidewall of the bit line and a sidewall corresponding to the first electrode or the first electrode dummy structure are respectively exposed on two opposite sides of the second accommodation groove in the first direction; the transistor comprises a semiconductor layer (41) conformally covering an inner sidewall of the corresponding second accommodation groove, and a gate insulating layer (42) conformally covering the semiconductor layer and the sidewall of the second hole; and the memory further comprises a word line (WL) covering the gate insulating layer and filling the second hole in the storage cell, and a selection line (SL) covering the gate insulating layer and filling the second hole in the selection cell; and
the connection cell further comprises a second filling layer (34) filling the second hole.

5. The memory according to claim 3, wherein each of the cells further comprises a second hole (H2) that is located between the bit line and the first hole and whose axis is perpendicular to the substrate; and
a sidewall of the bit line and a sidewall corresponding to the first electrode or the first electrode dummy structure are respectively exposed on two opposite sides of the second hole in the first direction; the access transistor and the selection transistor each further comprise a semiconductor layer (41) and a gate insulating layer (42) that are formed on an inner sidewall of the second hole, the semiconductor layers of adjacent access transistors in a direction perpendicular to the substrate are insulated from each other, and the semiconductor layers of adjacent selection transistors in the direction perpendicular to the substrate are insulated from each other; and the memory further comprises a word line (WL) covering the gate insulating layer and filling the second hole in the storage cell, and a selection line (SL) covering the gate insulating layer and filling the second hole in the selection cell; and
the connection cell further comprises a second filling layer (34) filling the second hole.

6. The memory according to any one of claims 1 to 5, wherein the bit line comprises a first part (BLa) opposite to the storage cell and the selection cell, and a second part (BLb) opposite to the connection cell;
wherein the second part and the common bit line are an integrated structure; and
the memory further comprises an isolation structure (5) located between the first part and the second part.

7. The memory according to claim 6, wherein
a same bit line corresponds to at least two connection cells; and
the isolation structure comprises a first isolation part located between the first part and the second part, and a second isolation part comprising at least a part of the second filling layer and being at least connected to the first isolation part.

8. The memory according to claim 6, wherein there are a plurality of bit lines, and the plurality of bit lines are insulated and arranged in a direction parallel to the substrate and are insulated and stacked in a direction perpendicular to the substrate; and
every two adjacent bit lines in a direction parallel to the substrate form a bit line group; and the cells corresponding to either bit line in the bit line group are located on a same side of the bit line that is away from the other bit line.

9. The memory according to claim 6, wherein there are a plurality of common bit lines, and the plurality of common bit lines are insulated and stacked in a direction perpendicular to the substrate; and
the memory further comprises a staircase structure (S) located on a side of the common bit line that is away from the bit line; and the staircase structure comprises a plurality of conductive stairs (S2) correspondingly coupled to the common bit lines.

10. A manufacturing method of a memory, comprising:
alternately stacking a plurality of first dielectric layers (L1) and a plurality of second dielectric layers (L2) on a substrate (1);
etching the plurality of first dielectric layers and the plurality of second dielectric layers along a direction perpendicular to the substrate, to form a first etching groove extending in a first direction (Y) parallel to the substrate, and at least one second etching groove located on a side of the first etching groove and extending in a second direction (X) parallel to the substrate, wherein the second direction intersects the first direction; and
etching the second dielectric layers in a direction parallel to the substrate based on the first etching groove, to form a plurality of common bit line accommodation grooves, and forming a common bit line (CBL) in the common bit line accommodation groove;
etching the second dielectric layers in a direction parallel to the substrate based on the second etching groove, to form a plurality of bit line accommodation grooves, and forming a bit line (BL) in the bit line accommodation groove;
etching the plurality of first dielectric layers and the plurality of second dielectric layers along the direction perpendicular to the substrate, to form an etching hole array, wherein the etching hole array comprises a plurality of etching hole groups located on a same side of the corresponding bit line and arranged in sequence in the second direction, the plurality of etching hole groups comprise a plurality of first etching hole groups (M1) distributed at intervals in the second direction, at least one second etching hole group (M2) located on a side of the plurality of first etching hole groups that is close to the common bit line, and at least one third etching hole group (M3) located on a side of the at least one second etching hole group that is close to the common bit line;
forming a storage cell (U1) based on the first etching hole group, wherein the storage cell comprises an access transistor (T1) coupled to a corresponding bit line;
forming a selection cell (U2) based on the second etching hole group, wherein the selection cell comprises a selection transistor (T2) coupled to a corresponding bit line; and
forming a connection cell (U3) based on the third etching hole group;
wherein the selection transistor corresponding to a same bit line is further coupled to the common bit line through the corresponding connection cell.

11. The manufacturing method of the memory according to claim 10, wherein the etching hole array is formed before the common bit line accommodation groove and the bit line accommodation groove are formed; and the first etching hole group, the second etching hole group, and the third etching hole group each comprise a first hole (H1) whose axis is perpendicular to the substrate;
the manufacturing method of the memory further comprises:
filling etching holes of the etching hole array with a third dielectric layer (L3);
removing the third dielectric layer from the first holes after the common bit line is formed;
etching the second dielectric layer in a direction parallel to the substrate based on the first hole, to form a first accommodation groove;
the forming a storage cell based on the first etching hole group comprises: forming a first electrode (21) conformally covering an inner sidewall of the corresponding first accommodation groove, forming a dielectric layer (22) conformally covering the first electrode and a sidewall of the first hole, and forming a second electrode (23) covering the dielectric layer and filling the first accommodation groove and the first hole; and
the forming a selection cell based on the second etching hole group and the forming a connection cell based on the third etching hole group each comprise: forming a first electrode dummy structure (31) conformally covering the inner sidewall of the corresponding first accommodation groove;
wherein the first electrode dummy structures in the selection cell and the connection cell corresponding to the same bit line are interconnected; the selection transistor in a selection cell is coupled to the first electrode dummy structure of the same selection cell; and the first electrode dummy structure in the connection cell close to the common bit line is coupled to the common bit line.

12. The manufacturing method of the memory according to claim 11, wherein the forming a selection cell based on the second etching hole group and the forming a connection cell based on the third etching hole group each further comprise:
forming a support electrode (32) covering the first electrode dummy structure and filling the first accommodation groove; and
forming a first filling layer (33) filling the first hole.

13. The manufacturing method of the memory according to claim 11, wherein the first etching hole group, the second etching hole group, and the third etching hole group each further comprise a second hole (H2) that is located between the bit line and the first hole and whose axis is perpendicular to the substrate;
the forming a storage cell based on the first etching hole group and the forming a selection cell based on the second etching hole group each comprise:
removing the third dielectric layer from the second hole;
etching the second dielectric layer in a direction parallel to the substrate based on the second hole, to form a second accommodation groove, wherein a sidewall of the bit line and a sidewall corresponding to the first electrode or the first electrode dummy structure are respectively exposed on two opposite sides of the second accommodation groove in the first direction;
forming a semiconductor layer (41) conformally covering an inner sidewall of the corresponding second accommodation groove; and
forming a gate insulating layer (42) conformally covering the semiconductor layer and a sidewall of the second hole;
wherein the manufacturing method of the memory further comprises:
forming a word line (WL) covering the gate insulating layer and filling the second hole in the storage cell, and a selection line (SL) covering the gate insulating layer and filling the second hole in the selection cell.

14. The manufacturing method of the memory according to claim 11, further comprising:
filling the first etching groove and the second etching groove with a first isolation layer (61) before the storage cell, the selection cell, and the connection cell are formed;
wherein the first etching hole group, the second etching hole group, and the third etching hole group each further comprise a second hole (H2) that is located between the bit line and the first hole and whose axis is perpendicular to the substrate; a sidewall of the bit line and a sidewall corresponding to the first electrode or the first electrode dummy structure are respectively exposed on two opposite sides of the second hole in the first direction; and the forming a storage cell based on the first etching hole group and the forming a selection cell based on the second etching hole group each comprise:
removing the third dielectric layer from the second hole;
sequentially forming an initial semiconductor layer (41A) and a gate insulating layer (42) on an inner sidewall of the second hole;
forming a word line (WL) covering the gate insulating layer and filling the second hole in the storage cell, and a selection line (SL) covering the gate insulating layer and filling the second hole in the selection cell;
removing the first isolation layer from the second etching groove;
etching the first dielectric layers in the first direction until a sidewall of the initial semiconductor layer that is away from the gate insulating layer is exposed;
etching to remove the initial semiconductor layer between any adjacent second dielectric layers to form a plurality of semiconductor layers (41) disposed at intervals in the direction perpendicular to the substrate; and
forming a second isolation layer (62) filling a spacing between the adjacent semiconductor layers, a region with the first dielectric layer being removed, and the second etching groove.

15. The manufacturing method of the memory according to claim 11, wherein one bit line corresponds to at least two connection cells; the first etching hole group, the second etching hole group, and the third etching hole group each further comprise a second hole (H2) that is located between the bit line and the first hole and whose axis is perpendicular to the substrate; and the forming a bit line in the bit line accommodation groove comprises:
forming an initial bit line (BLA) in the bit line accommodation groove;
removing the third dielectric layer in the second hole in any third etching hole group after the storage cell, the selection cell, and the connection cell are formed, and etching to cut off the initial bit line in a direction parallel to the substrate based on the second hole, to form the bit line (BL), wherein the bit line comprises a first part (BLa) opposite to the storage cell and the selection cell, and a second part (BLb) opposite to the connection cell; and
forming an isolation structure (5) in the cut-off region of the initial bit line and the second hole connected thereto.

16. The manufacturing method of the memory according to claim 15, wherein an end of the bit line accommodation groove close to the common bit line accommodation groove is connected to the common bit line accommodation groove; and the common bit line is simultaneously formed with the initial bit line;
wherein the second part of the bit line and the common bit line are an integrated structure.

17. The manufacturing method of the memory according to claim 15, after the forming the common bit line and the initial bit line and before the forming the storage cell, the selection cell, further comprising:
etching the plurality of first dielectric layers and the plurality of second dielectric layers in a direction perpendicular to the substrate, and forming a third etching groove on a side of the common bit line that is away from the initial bit line;
etching the first dielectric layers based on the third etching groove, to form a plurality of insulating stairs (S1);
etching the second dielectric layers based on the third etching groove, to form a plurality of conductive stair accommodation grooves, wherein a sidewall of the corresponding common bit line is exposed by the conductive stair accommodation groove;
forming, in the conductive stair accommodation groove, a conductive stair (S2) coupled to the common bit line, wherein the conductive stairs and the insulating stairs jointly form a staircase structure (S); and
forming a cover layer (82) covering the staircase structure.

18. A memory, comprising:
a common bit line (CBL), extending in a first direction (Y) parallel to a substrate (1);
a bit line (BL), located on a first side of the common bit line and extending in a second direction (X) parallel to the substrate, wherein the second direction intersects the first direction;
a dummy line (DL), a selection line (SL), and a word line (WL), all located on a first side of the common bit line, all located on a same side of the bit line, and all extending in a third direction (Z) perpendicular to the substrate, wherein the dummy line, the selection line, and the word line are arranged in sequence in the second direction and are sequentially away from the common bit line;
an access transistor (T1), coupled to the word line and the bit line;
a capacitor (C), located on a side of the access transistor away from the bit line and coupled to the access transistor; and
a selection transistor (T2), coupled to the selection line, the bit line, and the common bit line.

19. The memory according to claim 18, further comprising:
a connection electrode (9), located between the capacitor and the common bit line, wherein the selection transistor is coupled to the common bit line through the connection electrode.

20. An electronic device, comprising the memory according to any one of claims 1 to 9, 18 and 19, and a processor coupled to the memory.
